Europäisches Patentamt

(19) European Patent Office

Office européen des brevets

(11) **EP 0 429 196 B1**

(12) **EUROPEAN PATENT SPECIFICATION**

(45) Date of publication and mention
of the grant of the patent:
**27.03.1996 Bulletin 1996/13**

(51) Int. Cl.⁶: **B29C 39/42**, B29C 67/00

(21) Application number: **90311877.6**

(22) Date of filing: **30.10.1990**

(54) **Improved stereolithographic construction techniques**

Verbesserte stereolithographische Formgebungstechnik

Techniques de moulage stéréolithographiques améliorées

(84) Designated Contracting States:
**AT BE CH DE DK ES FR GB GR IT LI LU NL SE**

(30) Priority: **27.04.1990 US 516145**
**30.10.1989 US 429435**

(43) Date of publication of application:
**29.05.1991 Bulletin 1991/22**

(60) Divisional application: **95108985.3**

(73) Proprietor: **3D SYSTEMS, INC.**
**Valencia California 91355 (US)**

(72) Inventors:
• **Jacobs, Paul Frances**
**La Crescenta, California 91214 (US)**
• **Hull, Charles William**
**Santa Clarita, California 91350 (US)**
• **Smalley, Dennis Rollette**
**Baldwin Park, California 91766 (US)**
• **Allison, Joseph W.**
**Valencia, California 91355 (US)**

(74) Representative: **Frohwitter, Bernhard, Dipl.-Ing. et al**
**Patent- und Rechtsanwälte**
**Bardehle . Pagenberg . Dost . Altenburg .**
**Frohwitter . Geissler & Partner**
**Galileiplatz 1**
**D-81679 München (DE)**

(56) References cited:
**EP-A- 0 250 121**          EP-A- 0 388 129
**US-A- 4 575 330**

## Description

## BACKGROUND OF THE INVENTION

### Field of the Invention

This invention relates to the field of stereolithography, which is a technique for making solid, three-dimensional objects (or "parts") from solidifiable materials (e.g. fluid or fluid-like material such as photopolymers, sinterable powders, and bindable powders).

In recent years, stereolithography systems, such as those described in U.S. Pat. No. 4,575,330, issued March 11, 1986 and entitled "Apparatus for Production of Three-Dimensional Objects by Stereolithography," have come into use. Basically, stereolithography is a method for automatically building complex three-dimensional parts by successively solidifying thin cross-sectional layers. These layers may be composed of photopolymer resin powdered materials, or the like. Some types of powder materials are converted from a fluid-like medium to a cohesive cross-section by melting and solidification. The layers are solidified on top of each other consecutively until all of the thin layers are joined together to form a whole part. Photocurable polymers change from liquid to solid upon exposure to synergistic stimulation. Many photopolymers exist whose photospeed (rate of transformation from liquid to solid) upon irradiation with ultraviolet light (UV) is fast enough to make them practical model building materials. In a preferred system, a radiation source (e.g., an ultraviolet laser) generates a beam which is focused to a small intense spot which is moved across the liquid photopolymer surface by galvanometer or servo type mirror x-y scanners. The scanners are driven by computer generated vectors or the like. The material that is not polymerized when a part is made is still functionable and remains in the vat for use as successive parts are made. With this technology, the parts are literally grown from a vat of fluid-like material (e.g. resin or powder). Specifically, the parts are grown from a thin layer near a surface of the vat of fluid-like material. In this manner precise complex three dimensional patterns can be rapidly produced. This method of fabrication is extremely powerful for quickly reducing design ideas to physical form for making prototypes.

This technology typically utilizes a stereolithography apparatus, referred to as an "SLA," which generally includes a laser and scanner, a photopolymer vat, an elevator, and a controlling computer. The SLA is programmed to automatically make a three-dimensional part by forming it as a sequence of built-up cross-sectional layers.

Stereolithography represents an unprecedented way to quickly make complex or simple parts without tooling. Since this technology depends on using a computer to generate its cross-sectional patterns, there is a natural data link to computer aided design and manufacture (CAD/CAM). However, such systems have presented challenges relating to structural stress, shrinkage, curl and other distortions, as well as resolution, speed, accuracy and difficulties in producing certain object shapes.

### Related Patents and Applications

The following U.S. patents and U.S. Patent applications are incorporated by reference into this disclosure as though fully set forth herein:

4,575,330
07/429,435
07/331,664
07/269,801
07/182,830
07/415,134
07/339,246
07/182,801
07/183,015
07/183,012
07/268,429
07/429,911
07/415/168
07/265,039
07/249,399
PCT/US89/04096
07/429,301,

Entitled:     Improved Systems For Post Processing Objects Formed In A Stereolithography Apparatus.

The instant application is a continuation-in-part of U.S. Patent Application Serial No. 07/429,435, which in turn is a continuation-in-part of U.S. Patent Application Serial Number 07/331,664, which is in turn a continuation-in-part of U.S. Patent Application Serial No. 07/269,801, which is in turn a continuation-in-part U.S. Patent Application Serial No. 07/182,830. U.S. Patent Application Serial No. 07/429,435 describes some main features of the present invention. U.S. Patent Application Serial No. 07/331,664 describes in great detail the presently preferred stereolithographic apparatus, as well as various methods to form parts therewith. This application is incorporated herein by reference, including its appendices, as though fully set forth herein to facilitate handling due to its relatively lengthy disclosure. Two reference manuals, The SLA-250 User Reference Manual and The SLA-500 Reference Manual are hereby incorporated into this disclosure by reference as though fully set forth herein and accompanied U.S. Patent Application Serial Number 429,435 as Appendices B and C respectively.

U.S. Patent 4,575,330 to Hull discusses stereolithography in general. It teaches complete polymerization of each cross-section in the formation of a stereolithographically-formed object.

U.S. Patent Application Serial No. 07/415,134 describes off-absorption-peak wavelength post curing of parts which were formed based on the primary approach to building stereolithographic parts.

U.S. Patent Application Serial No. 07/339,246 describes several methods of reducing curl distortion.

U.S. Patent Application Serial Number 07/182,801 describes the use of web supports to support and minimize curl in a part being formed.

U.S. Patent Application Serial No. 07/183,015 describes the use of "smalleys" to minimize curl.

U.S. Patent Application Serial No. 07/429,911 describes the use of multiple penetration depths in the stereolithographic process, along with the use of beam profile characteristics in combination with resin parameters to predict various cure parameters associated with the creation of stereolithographic parts. This application also describes the role of beam profile information in the creation of skin fill and discusses various multiple wavelength curing methods for reducing part distortion.

U.S. Patent Application Serial Nos. 07/415,168, 07/268,429, and 07/183,102 disclose various methods of finishing a stereolithographic part surface to smooth out discontinuities in a post-processing step.

U.S. Patent Application Serial Nos. 07/265,039 and 07/249,399 which together form the basis of PCT Application Serial No. PCT/US89/04096 disclose the use of a doctor blade for obtaining a uniform coating of resin of known thickness over each cross-section of a stereolithographic part as well as a system for maintaining a known surface level of the building material as the part is being built.

U.S. Patent Application Serial No. 07/429,301 discusses post-processing techniques.

In the normal practice of stereolithography, objects or "parts" are built on a layer-by-layer basis, where each layer represents a thin cross-section of the part to be formed. Initial approaches to stereolithographic part building were based on the complete filling (e.g. substantial polymerization of all regions of a cross-section to a thickness at least as deep as the layer thickness) of layers. This filling was either done by the scanning of a pencil of light, by a focusable (defocusable) pencil of light, or by flood exposure of an appropriate cross-sectional image. The pencil of light approach strictly used complete filling of cross-sections based on the scanning of adjacent overlapping vectors until the entire cross-sectional pattern was cured. These initial approaches suffered from several drawbacks, including distortion, curl, inaccurate sizing, lack of structural integrity, and lack of uniformity in down-facing surface appearance.

Later stereolithographic techniques used an internal lattice of partially cured building material ("cross-hatch" or "hatch") in place of completely filling the successive cross-sections. The internal structures primarily consisted of cross-hatch separated by untransformed building material (e.g. liquid photopolymer or the like). In this approach, the outer and inner edges of each layer are solidified by scanning of what are called "boundary vectors" (also termed, "boundaries" or "border vectors" or "borders"). These vectors separate the interior solid regions of a cross-section from exterior untransformed building material. Cross-sections or portions of cross-sections that bound external regions of the part are completely filled with skin fill (termed "fill" or "skin") after being cross-hatched. The hatch insured adequate support for the "skin" as it is being created, thereby minimizing distortion.

The skin, crosshatch, and borders trap untransformed building material (e.g. liquid photopolymer) internally in the part structure and hold it in place while the part is being created. The trapped untransformed building material (e.g. liquid photopolymer) and at least partially transformed building material (e.g. at least partially cured polymer) which forms the boundaries, hatch, and skin are brought to full transformation (e.g. polymerization) in a later process known as "post curing". For additional information on post-curing, see U.S. Patent Application Serial No. 07/429,301, directed to the post curing process.

Fairly extensive post-curing can be required when the internal cross-hatch lattice only defines discrete x-z and y-z, planes, or the like, which are separated from each other by more than the width cured by a beam, as in such cases long vertical corridors of unpolymerized material remain substantially uncured until post-processing.

Stereolithographic building techniques have upon occasion resulted in down-facing features having a "wafflish" appearance and texture. This appearance and texture are due to inappropriate curing techniques being used on regions of layers that contain down-facing features. When down-facing features are given both hatch and skin fill, there can be overexposure of the regions where the hatch and fill coincide. Similarly, overexposure can occur at the points of intersection of crosshatch vectors. In the past, it has been possible to ignore the requirement of uniform cure depth for down-facing features, since other accuracy-related errors overshadowed this effect. However, as the stereolithography art strives for and attains increasingly higher levels of accuracy, imperfections such as these can no longer be overlooked.

Traditionally, the methods used to estimate skin depth were only guesses that had a remote connection to actual experimental data or theoretical expectations. The actual skin thicknesses obtained by these traditional approaches were strongly dependent upon beam profile characteristics, skin vector spacing, drawing speed, and resin characteristics. However, these parameters were not coordinated to yield a particular skin thickness. For example, skin thicknesses intended to be 0,508 (20 mils) could easily range from 0.381 to 0.635 mm (15 to 25 mils). In the past, this type of thickness range has been tolerated, but as the art of stereolithography advances, there is an increasing need for more accurate and less cumbersome methods of predicting the required exposure to obtain a desired skin thickness.

From the EP-A-0 250 121 a stereolithographic apparatus and a corresponding method is known for constructing a three-dimensional object layer-by-layer from a fluid-like material solidifiable upon exposure to synergistic stimulation. The apparatus described comprises a laser radiating a beam via a beam modulator and deflector onto the respective layer. The beam modulator and deflector receives a data input from a computer or storage medium. The modulated and deflected beam impinges on a layer of solidifiable liquid lying in a solidification plane. The solidifiable liquid is located in a container being supported on a container positioning mechanism. The data received by the beam modulator and deflector may be of any suitable form and is typically provided in the raster-format, vector-form, or a combination thereof. According to another embodiment of this prior art approach the solidifiable liquid is exposed by using a conventional projection system together with photographic exposure masks. The pattern to be projected on the liquid is broken down into two complementary pattern masks. The respective solidifiable layer is exposed through each of the complementary pattern masks separately, such that distortions due to shrinkage following the first exposure are at least partially compensated during the second exposure.

According to the EP-A-0 388 129 (which is prior art in accordance with Art. 54 (3), (4) EPC as far as the designated countries DE, FR, GB and NL are concerned) a further stereolithographic apparatus for constructing a three-dimensional object layer-by-layer from a fluid-like material solidifiable upon exposure to synergistic simulation is known. The apparatus according to this prior art approach consists of a tank containing the fluid-like material and an elevator and the like a beam scanning section for focusing an exposure beam to scan a liquid surface of the fluid-like material, and a control section for controlling the operations of the beam scanning section and the elevator. The beam scanning section is able to deflect the exposure beam in a first scanning direction relative to the liquid surface and a second scanning direction perpendicular to the first direction. With such a beam scanning section, the stereolithographic apparatus is able to perform raster-scanning and vector-scanning of the respective layers. In the raster scanning mode the layers are exposed by scanning the beam spot in a straight line-shaped main scanning direction across the layer such that a plurality of parallel extending exposed lines result. In the vector scanning mode, scanning proceeds with the scanning direction being a direction defined by vector data. According to the method discussed, vector scanning is used for the exposure of the boundary portion of the layers, whereas raster scanning is used for the exposure of non-boundary portions of the layers.

In view of the above it is the object of the present invention to provide an improved stereolithographic method and apparatus substantially reducing the horizontal distortions within the layers of the three-dimensional objects.

This object is solved by a stereolithographic method for constructing a three-dimensional object in accordance with claims 1 of claim versions A and B and the corresponding apparatus in accordance with claim 18 of claim version A and claim 19 of claim version B.

Further embodiments of the invention are disclosed in the dependent claims.

According to a further aspect of the present invention, a method provides boundaries appropriate to each cross section and provides cross-sections with at least two types of non-parallel hatch vectors wherein effective adhesion (that capable of transmitting significant curl) only occurs at the overlapping points between the vectors of the two hatch types. Additionally the hatch vectors of each type are spaced as close together as possible without being spaced so close that they can induce curl into adjacent vectors or have curl induced in them by adjacent vectors.

According to another aspect of the invention, a method comprises the steps of providing boundaries appropriate to each cross-section and providing cross-sections with at least two types of non-parallel hatch vectors that are offset from their corresponding types on the previous layer wherein effective adhesion between cross-sections (that capable of transmitting significant curl) only occurs near the overlapping points between the vectors of the two hatch types of the present layer. Additionally, the hatch vectors of each type are spaced as close together as possible without being spaced so close that they can induce curl into or have curl induced in them by adjacent vectors or transmit curl from one vector to another vector.

According to another aspect of the invention, each region of a cross-section that is internal to the object (i.e. not forming a down-facing or up-facing region), is cured in the form of point exposures, "bullets". The point exposures on successive layers are offset one from another, and the bullets are cured to approximately a depth of one layer thickness. The spacing of the point exposures on a single layer are as close together as is reasonable without the material cured in association with each bullet affecting the material cured in association with adjacent bullets. In this approach the up-facing and down-facing features may be formed by a variety of techniques.

According to yet another aspect of the invention, each region of a cross-section that is internal to the object (i.e. not forming a down-facing or up-facing region), is cured in the form of point exposures, "bullets", wherein the bullets are cured to a depth substantially equal to two layer thicknesses, and wherein bullets on successive layers are offset one from another. The positioning pattern is repeated every other layer, and the spacing of the bullets on each cross-section is such that their cured separation is greater than zero but less than their cure width one layer thickness below their upper surface. The bullets cured on the present layer substantially fill in the gaps left in the previous cross-section when it was formed. In this approach the up-facing and down-facing features may be formed by a variety of techniques.

According to another aspect of the invention, each region of a cross-section that is internal to the object and exists on the present cross-section as well as the N-1 succeeding cross-sections, is cured in the form of point exposures, "bullets". Each cross-section is divided into a pattern of slightly overlapping bullets. These bullets are divided up into N groups where the bullets associated with successive groups are used to expose material in association with the successive cross-sections beginning with the present cross-section. Each bullet is cured to a depth substantially equal to N layer thicknesses. In this approach, regions of cross-sections within N-2 layers of a down-facing feature are handled by modified techniques similar to those described above, and the up-facing and down-facing features may be formed by a variety of techniques.

According to yet another aspect of the invention, at least up- and down- facing features are provided with skin fill that is created by scanning in a first pass using non-adjacent fill vectors, followed by scanning in at least one additional pass that completes the exposing process by filling in between the originally drawn vectors.

In another aspect of the invention, regions of intersecting vectors at least in down-facing surfaces are determined, and exposure of one or more of the respective intersecting vectors at these intersecting regions is reduced, such that at least the down-facing features have a uniform exposure.

In another aspect of the invention, a region that contains a combination of hatch and fill vectors is created and cured to a uniform depth. The creation of this region comprises the steps of creating the desired hatch vectors, and then creating corresponding skin fill types that do not contribute to additional exposure of the regions of their corresponding hatch vectors.

In another aspect of the invention, an improved stereolithographic method comprises determining necessary exposure and vector spacing and scanning parameters in order to obtain a known thickness of skin fill.

In still another aspect of the invention, a stereolithographic method comprises the steps of constructing stacked layers to form an object having external boundaries, internal cross hatch, and skinned up- and down-facing features. Specifically, this method comprises the steps of: (a) selecting layers to be provided with skinned surfaces; (b) providing means for calculating the amount of total exposure required to obtain skin curing of a preselected depth at the layers selected to have skinned surfaces; (c) providing means for determining the number of vectors that will be exposing each region in the layers, and (d) providing means for at least partially transforming (e.g. polymerizing) the layers by exposing them first to boundary vectors, then to hatch vectors, and then to skin vectors, each vector providing an exposure sufficient to cure to the preselected depth calculated in step (b), divided by the number of other vectors that will intersect the vector at a given region as determined in step (c).

According to other aspects of the invention, these improvements are used in combination with one another and/or in combination with curl reduction techniques as described in: U.S. Patent Application Serial No. 07/339,246; U.S. Patent Application Serial No. 07/183,015; U.S. Patent Application Serial No. 07/182,801, and the other applications cited previously all of which are fully incorporated herein by reference. For example, according to yet another aspect of the invention, an improved stereolithographic method is disclosed comprising the combined use of hatch with nonconsecutive skin fill in more than the up- and down- facing features. As another example, an improved stereolithographic method is disclosed comprising the method of reducing exposure where vectors intersect and providing discontinuities in skin fill to avoid multiple vector exposure in regions where hatch vectors have been provided.

Other aspects of the invention, together with objects and attendant advantages of the various embodiments, will best be understood from an examination of the drawings along with the detailed description below.

## BRIEF DESCRIPTION OF THE DRAWINGS

FIGURES 1a-1d collectively show a top view of a layer showing boundaries, hatch and skin without compensation for multiple exposures of building material at the various regions of the cross-section. FIGURES 1a-1d represent respectively: a) boundaries only; b) crosshatch only; c) skin only; and d) combined vectors.

FIGURES 2a-2d collectively show a side view of FIGURE 1d as intersected by various vertical planes. FIGURES 2a-2d represent, respectively: a) repeat of FIGURE 1d with vertical planes; b) a view of the edge of the layer along plane 1 showing the various depths obtained in different regions; c) a view of the edge of the layer along plane 2 showing the various depths obtained in different regions; and d) a view of the edge of the layer along plane 3 showing the various depths obtained in different regions.

FIGURES 3a-3e collectively illustrate a top view of a layer showing boundaries, hatch and skin as created by a presently preferred technique. FIGURES 3a-3e represent respectively: a) boundaries only; b) crosshatch only; c) skin type 1; d) skin type 2; and e) combined vectors.

FIGURES 4a-4d collectively show a side view of FIGURE 3e as intersected by three different vertical planes. FIGURES 4a-4d represent, respectively: a) repeat of FIGURE 3e with vertical planes; b) a view of the edge of the layer along plane 1 showing the various depths obtained in different regions; c) a view of the edge of the layer along plane 2 showing the various depths obtained in different regions; and d) a view of the edge of the layer along plane 3 showing the various depths obtained in different regions.

FIGURES 5a and 5b illustrate the profiles of a cured "string," corresponding to the cure produced by a single vector.

FIGURES 6a-6d show down-facing surface profiles of parts made in accordance with Example II below.

FIGURES 7a-7c show a comparison between traditional vector ordering techniques and examples of various vector ordering techniques of some of the preferred embodiments of the present invention. FIGURE 7a depicts a top view of a cross-section of an object showing a consecutive drawing order for the vectors. FIGURE 7b depicts the same cross-section but filled using a non-consecutive order that fills the cross-section in two passes. FIGURE 7c depicts the same cross-section but filled using a non-consecutive order that fills the cross-section in three passes.

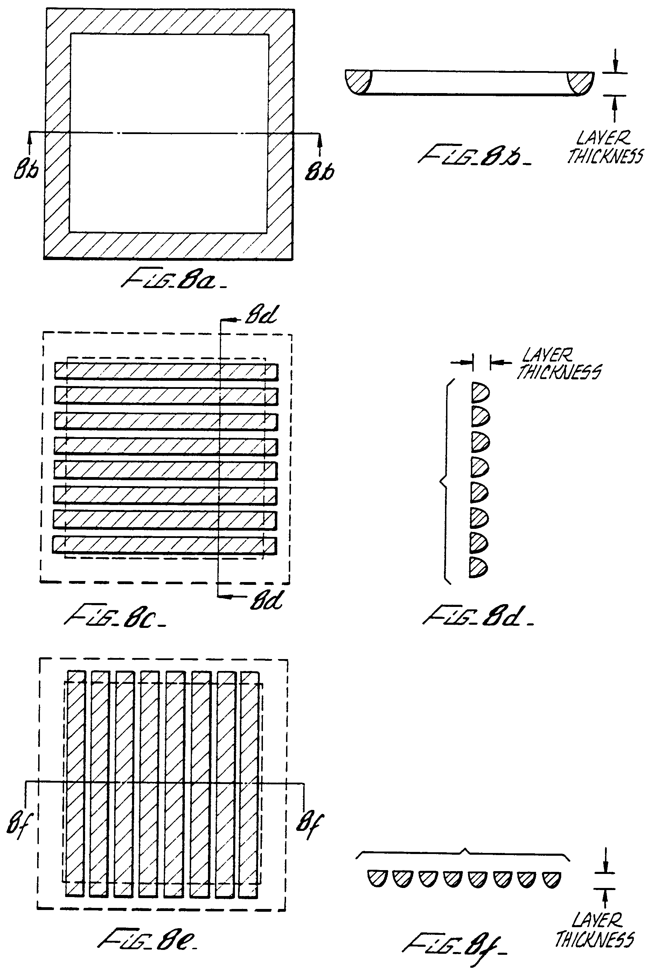

FIGURES 8a-8i collectively illustrate the vectors used and cure depths obtained, for a sample cross-section, by utilizing the "weave" building embodiment. FIGURES 8a, 8c, and 8e respectively represent top views of boundary vectors, X hatch vectors, and Y hatch vectors. FIGURES 8b, 8d, and 8f depict side views of the material cured in association with FIGURES 8a, 8c, and 8e respectively. FIGURE 8g represents a top view of the combination of material cured by the individual vector types of FIGURES 8a, 8c, and 8f. FIGURE 8H and 8I represent side view of the cure depths associated with two different vertical planes intersection the cross-section of FIGURE 8g.

FIGURES 9a and 9b collectively show a side view indicating the difference between stacking one direction of crosshatch on top of each other from layer to layer and staggering the hatch from layer to layer. FIGURE 9a depicts a side view of hatch being stacked on top of each other from layer to layer. FIGURE 9b depicts a side view of hatch being staggered from layer to layer.

FIGURES 10a-10c collectively show the configuration of bullets cured in association with practicing the seventh embodiment of the present invention. FIGURE 10a depicts a top view of the boundary and bullets cured on a first cross-section. FIGURE 10b depicts a top view of the boundary and bullets cured on a second cross-section. Comparison of FIGURES 10a and 10b indicate that the bullets are staggered from the first to the second layer. FIGURE 10C depicts a side view of the boundaries and bullets of five cross sections stacked one on top of the other.

FIGURE 11 illustrates a side view of the overlapping nature of the bullets formed in practicing the eighth embodiment of the present invention.

FIGURE 12 depicts the three-dimensional object used in Example 1 to test the improvements of "skintinuous" building.

FIGURE 13 depicts a top view of the uppermost cross-section of the part of FIGURE 12, along with indications as to what measurements were made on the part; and

FIGURES 14a and 14b collectively depict a side view of a CAD designed object and the object as reproduced according to the teaching of the first preferred embodiment of the present invention. FIGURE 14a depicts the CAD designed object, and FIGURE 14b depicts the reproduction.

FIGURES 15a, 15b, and 15c collectively depict the part used in the experiment of Example VI. FIGURE 15a depicts a three-dimensional view of the part. FIGURE 15b depicts a top view of the part. FIGURE 15c depicts an exaggerated top view of the distortion of the part after post curing.

FIGURES 16a, 16b, and 16b′ collectively depict sample cross-sections of an object for the purpose of distinguishing up-facing and down-facing features of an object and the relationship of such features to subregions of each cross-section. FIGURE 16a depicts a top view of the bounded and unbounded regions of a single sample cross-section. FIGURE 16b depicts a side view of three sample cross-sections of an object. FIGURE 16b′ depicts a side view of the subregions of the middle cross-section.

FIGURES 17a-g illustrate various patterns and shapes for tiling and the weak bending axes, if any, associated with each pattern/shape combination.

## DETAILED DESCRIPTION OF THE PREFERRED EMBODIMENTS

The instant invention addresses alone or in combination four improvements in stereolithographic methods. These are, first: methods of increasing structural integrity while reducing the need for post-curing; second: methods of obtaining uniform exposure in regions of intersecting vectors of different types; third: methods of determining cure depth; and fourth: methods intended to reduce distortion due to shrinkage, curl, and post cure. Although these three aspects of the invention are closely inter-related and are often cross-dependent, they will be addressed in sequence in this detailed description, and will also be illustrated in the examples below.

## Definitions

"Beam profiles" represent the energy distribution of irradiation in a beam of ultraviolet light or the like, used to cure photopolymer or other curable material in accordance with stereolithography practices.

"Building materials" are materials that can be used in the present invention for forming three-dimensional parts. The acceptable building materials are materials that can transform from one state to another state in response to exposure to synergistic stimulation. The two states are then separable after exposure of a single layer to synergistic stimulation or separable after completion of a plurality of layers. The most preferred materials are materials that transform from a fluid-like state to a cohesive state or solid state. These materials include liquid photopolymers, sinterable powders, bindable powders or the like. Prior to exposure to appropriate synergistic stimulation (e.g. IR radiation from a Carbon Dioxide laser or the like) the sinterable powders are in a fluid-like state since the powder particles can flow past one another whereas after sintering the powder particles are joined to form a cohesive mass. Similarly the bindable powders are in a fluid-like state prior to exposure to appropriate synergistic stimulation (e.g. a chemical binder dispensed into the powder in a selective and controlled manner) whereas after exposure the binder sets and the powder (and binder) form a cohesive mass. The most preferred of the above materials for the present invention are the photopolymer type materials. Other acceptable materials include relatively solid sheets of material that are transformable from one state to another. These sheet like materials include "dry film" type photopolymer materials that can be solidified upon exposure to appropriate synergistic stimulation wherein after exposure the exposed and unexposed materials can be separated by differential solubility in an appropriate solvent.

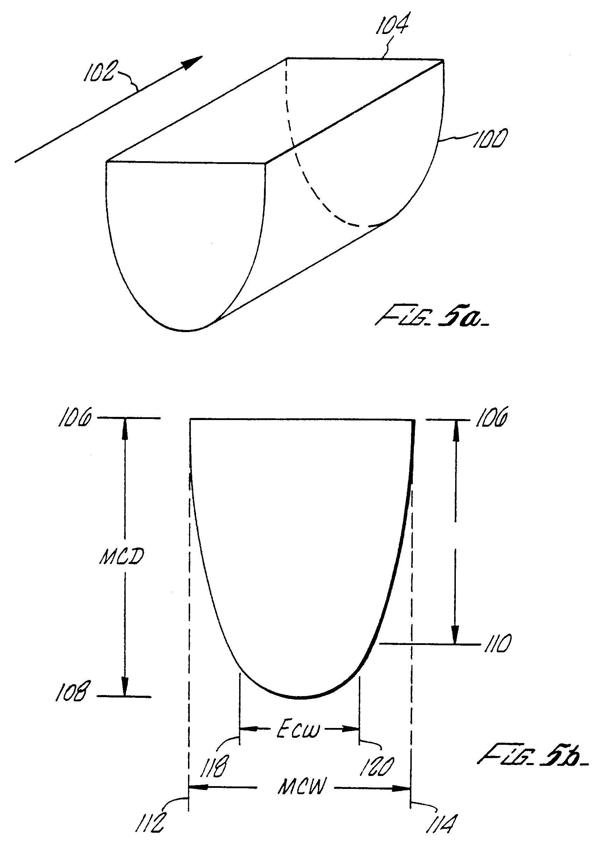

"Bullets" are volumes of a building material which are solidified in response to a beam of synergistic stimulation exposing the material in substantially single non-overlapping point irradiations. The usual shape of the cured material is similar to that of a bullet. FIGURE 5b depicts a cross-sectional view a line or vector of material cured by a beam of radiation. It can equally well be interpreted as depicting a two dimensional view of a bullet, wherein the three-dimensional bullet would be the volume of revolution formed by rotating the object about a vertical axis through its center.

"Effective Cure Width" (ECW) is a distance equal to twice the closest possible spacing of two vectors from one another that will render a given individual cure depth (i.e., a cure depth associated with each vector) without measurably increasing the cure depth of the combination. For the preferred beam profiles and cures, the Effective Cure Width (ECW) is always less than the Maximum Cure Width (MCW) (i.e., the width of the solidified string at the building material surface), such that different lines of solidified material can be adhered without an increase in cure depth. For example, in FIGURE 5b, the horizontal separation between lines 118 and 120 might represent the ECW for string 100. Typically, one half the ECW represents the closest point that a similar line of material can approach string 100 without measurably increasing its maximum cure depth. More generally, the ECW is a zone that surrounds the center line of a string, such as string 100, that represents the closest position that another string (of arbitrary thickness and direction) of solidified material or set of strings of material can approach the first string without resulting in the maximum cure thickness of the combination being measurably greater than the maximum thickness of either string. As two non-parallel vectors approach an intersection point, the excess exposure point, "EEP" (the point at which the combination will cause measurable increase in cure depth) is determined by the beam profile and angle of approach of the two vectors. If the vectors are perpendicular the excess exposure point is the 1/2 the ECW. If the vectors approach each other at a 45 degree angle the excess exposure point is at 1/2 x 1.414 x ECW. An approximate relationship between ECW, the angle of approach, and the EEP is

$$EEP = (1/2) \times ECW / SIN(A),$$

where A is the angle between the vectors. A more accurate relationship can be derived from information regarding the beam profile, the depth of cure, the building material response characteristics, and the intersection direction of the vectors.

"Layers" are the incremental thicknesses between successive cross-sections into which an object is divided. These layers form the basis for the thicknesses of building material (e.g. photopolymer). They must receive sufficient exposure to synergistic stimulation (e.g. ultraviolet light or other polymerizing radiation) to transform from their fluid-like state into a cohesive structure. The layers are constructed to adhere to one another and collectively form a solidified (e.g. polymerized or partially polymerized) stereolithographically produced part.

"Maximum Cure Depth (MCD)" and "Maximum Cure Width (MCW)" refer, respectively, to the deepest and widest cure that is obtained when exposing a single line or bullet of uncured building material to synergistic stimulation. The maximum cure depth is generally what is referred to as the cure depth of boundary and hatch lines. Since the beam of light is not generally of constant intensity across its width, the cure depth and width caused by this beam tracing across a line one or more times does not produce a uniform depth and width of cure. The maximum depth of cure generally occurs near the middle of a cross-section of the trace but it can actually occur anywhere depending on the distribution of intensity in the beam. It may also depend on the direction of scanning of the beam in forming the trace. The maximum width of cure occurs at the top (surface) of the cured line of material. An example of the maximum depth and width of cure are depicted in FIGURE 5a which shows a line (sometimes called a string) of cure material 100. Vector 102 indicates the scanning direction used in creating the string of material 100. Surface 104 represents the solidified material that was created from the fluid-like material that formed part of the surface of the curable material. FIGURE 5b represents an end-on view of string 100. Line 106 indicates the position of the top of the cured string 100, while line 108 represents the bottom of cured string. The vertical distance between 106 and 108 is the maximum cure depth of string 100. Line 112 represents the left-most edge of string 100, while line 114 represents the right-most edge of string 100. The horizontal separation between 112 and 114 is the maximum cure Width of string 100. Such a string 100 of solidified building material may be used for several purposes: 1) to insure adhesion between the layer associated with its creation and the preceding layer, 2) to form a down-facing feature of a part being created, and 3) as an element of a series of such strings of cured material, where the series will be used for one of the above two purposes. An up-facing feature is not included in the above since it can be fit into one of the above categories depending on the situation. For the first purpose listed above, maximum cure depth may preferably be greater than the layer thickness. The vertical separation between line 106 and line 110 represents the layer thickness in such a case. For the second purpose the MCD represents the layer thickness, and for the third purpose the vertical separation between line 106 and line 116 might represent the layer thickness since the net thickness of the cured material might increase from the segments overlapping each other.

"Overlapping" refers to two or more exposures being given to a region so that an increase in maximum cure depth occurs. Since cure profiles are not necessarily step functions, two separately exposed areas can touch and bind to one another without changing the maximum cure depth of either. When two lines are exposed beside one another their maximum widths may overlap resulting in a larger exposure in this region, and a corresponding increase in depth. But if this additional exposure does not occur in the region near the maximum cure depth of the individual lines, their combined maximum cure depth will not generally be measurably deeper than their individual maxima. Overlapping sometimes refers to situations when two side by side exposures affect the curing of each other whether or not they result in an increase in the maximum cure depth of either one. The context in which the term "overlapping" is used will generally make its meaning clear.

"Step Period" (SP) is a part-building parameter that defines the period between each laser step.

"Step Size" (SS) is a part-building parameter that defines the size of the step moved by the laser spot on the building material surface.

"Vectordata" is data that represent the length and direction and length of irradiation exposure in the process of solidifying the building material in the preferred embodiment of the present invention.

"Vectors" are exposure lines defined by the vector data and resulting from e.g. a scanning beam of ultraviolet radiation, on a liquid photopolymer, or other fluid-like, solidifiable mediums.

"Skin" vectors are horizontal surface vectors that are typically traced from one boundary to an opposing boundary at relatively high speed and with a substantial overlap between successive vectors which are generally traced in opposite directions, and typically form "skin fill" which defines at least the upper and lower horizontal exterior surfaces of a stereolithographically-formed part in traditional stereolithography and in several of the preferred embodiments of the present invention. Typically, skin vector spacing is from about 0.0254 (1) to about 0,102 mm (4 mils) for a maximum cure width of a single exposure being about 0,356 to 0,381 mm (14 to 15 mils). Of course, these exemplary and illustrative parameters can be varied as needed based upon such considerations as the desired smoothness of the layers, the power of the laser, the possible speed range of the irradiating source (i.e., the maximum drawing speed), the layer thickness desired, and the number of vectors that are desired to be stored. According to certain aspects of this invention, however, skin fill is provided in more than the exterior surfaces of the part. According to other aspects of the invention, skin vectors can be drawn non-consecutively and/or nonoverlapping (e.g., a first pass at 0,178 - 0,203 mm (7-8 mil) intervals and a subsequent pass at intervening intervals). These aspects and others are described in detail below.

"Boundary" vectors are traced to define the vertical exterior surfaces of the stereolithographically-formed part (therefore to define the range of each cross-section). These vectors generally are scanned more slowly than skin vectors such that a greater cure depth is obtained. Boundaries, unlike skin fill, generally do not rely on overlapping offset passes to attain their full cure depth. In situations where regions on a given layer overlap regions of the previously formed layer (non-down-facing regions), it is preferred that the cure depth exceed the layer thickness, so that improved adhesion between layers results. In regions of down facing features, it is preferred that net cure depth be substantially equal to the layer thickness.

"Hatch" vectors are similar to boundary vectors, except that they are traced in a substantially uniform, criss-cross type pattern, to define the internal lattice structure of the stereolithographically-formed part. Again, it is preferred that the cure depth exceed the layer thickness, if being drawn in a non-down-facing region, so that improved adhesion between layers results. If being drawn in a down-facing region, then layer thickness cure depth is preferred. In several preferred embodiments of the present invention, adhesion between layers is obtained by the extra cure depth that is obtained from the intersections of two or more crosshatch vectors wherein the cure depth of the individual hatch lines is insufficient to cause curl inducing adhesion between the layers.

"Skintinuous" in general terms describes any building technique which generates a substantially solid fill pattern over a substantial portion of the cross-sectional area of a part.

"Multipass" refers to a drawing technique which utilizes more than one pass to expose a region (e.g. a line) so that the material is substantially reacted before direct adhesion with surrounding structures takes place. The purpose of this method is to minimize pulling forces between layers and therefore to reduce curl.

"Interrupted Scan" or "Bricking" refers to scanning a vector with recurring gaps to relieve transmitted stress.

"Tiling" is an interrupted scanning technique that applies to relatively wide regions as opposed to vectors (the wide regions may be made up of vectors). This scanning results in distinct shapes which fit together very snugly but are not adhered to each other. The intention of this method is to maximize percentage of build process curing while reducing transmitted stresses that generate curl.

"Log Jam" refers to a scanning technique where some internal hatch (or fill) vectors are retracted from the layer borders to avoid adhesion, wherein after exposure of the hatch or fill an offset border or the like is scanned to attach the hatch and original border.

"Quilting" refers to a drawing technique which first partitions each layer into patches by scanning a relatively large crosshatch structure. Each patch is then treated as an individual region to be scanned. This method relieves problems that can arise when drawing relatively large regions with floating material techniques (e.g. log jam).

"Strongarm" refers to a scanning technique wherein a down-facing region is given extra exposure to make it extra rigid thereby increasing its ability to resist distortion caused by adhesion with material from the next higher layer.

"Weave" generally refers to any drawing pattern which generates a near solid fill pattern, wherein vectors on the first pass (threads) are spaced slightly further apart than the maximum cure width (MCW) and have exposures that are less than that necessary for adhesion (i.e. under cured). Adhesion is obtained on a second pass or higher order pass by cumulative exposure resulting at the intersecting regions of threads. These intersecting regions are sometimes called stitches.

"Interlace" is a particular type of "non-consecutive scanning" wherein every other vector is scanned on a first pass of a region and the other vectors are scanned on a second pass.

"Staggered" refers to a building method where different drawing patterns are used on alternating layers. For example staggered hatch refers to offsetting or shifting the hatch vectors on every other layer so that the hatch vectors on adjacent layers do not overlay each other. The intended purpose of this method is to produce a more homogeneous structure and possibly to reduce curl in some instances.

"Smalleys" refer to a building technique where holes or gaps are placed at critical locations on a given cross-section (generally implemented through the CAD design but they can be implemented from a Slice type program onto individual cross-sections). They reduce curling by interrupting the propagation of stresses from one region of a layer to another region of the layer.

"Riveting" or "Stitching" refers to an exposure technique that applies different levels of exposure to a given layer, wherein some of the exposures are less than that necessary for adhesion and some of the exposures are sufficient to cause adhesion thereby creating discrete locations of adhesion which might resemble rivets.

"Webs" are support structures that are not a portion of a desired final reproduction of a CAD designed object but they are formed along with the object by the stereolithography apparatus to give support to various features of the object and to allow easy separation of the object from the building platform.

"Up-facing and Down-facing Features of an Object" are regions or subregions on particular cross-sections that represent an upper or lower extent of the object.

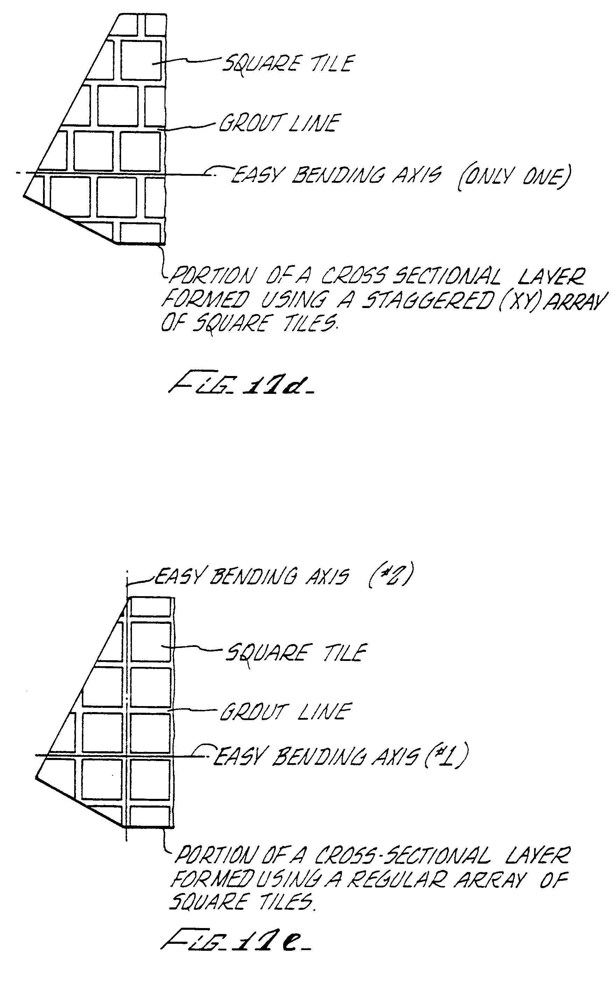

Each cross-section is formed from a combination of bounded and unbounded regions. Bounded regions are those that form a portion of the solid structure of an object (regardless of whether the region is formed as a completely solidified region or as a cross-hatched region). Unbounded regions are those that form an empty or hollow portion of an object. These concepts are depicted in the example of FIGURE 16a. FIGURE 16a depicts a top view of a sample cross-section of an object. This sample cross-section can be divided into three bounded regions and two unbounded regions. Boundary 700 bounds region 705, boundary 710 bounds region 715, and boundary 720 and 725 bounds region 730. Regions 735 and 740 are unbounded regions.

Each of the bounded regions of a cross-section may be divided into subregions, which are determined by relationships between bounded regions on a given cross-section and bounded and unbounded regions on the two adjacent (one higher and one lower) cross-sections. Up-facing regions of cross-section "i" are those bounded subregions of cross-section "i" that are underneath unbounded subregions of cross-section "i + 1". The down-facing subregions of cross-section "i" are the bounded subregions of cross-section "i" which overlay unbounded subregions of cross-section "i - 1". Some subregions may represent both up-facing and down-facing features; in this case the subregion is generally considered to be a down-facing subregion since appropriate curing of down-facing features is generally more critical than curing of up-facing features. This concept is depicted in the example of FIGURE 16b and 16b′. Cross-section "i" 750 is above cross-section "i - 1" 755 and is below cross-section "i + 1" 760. FIGURE 16b′ is a repeat of FIGURE 16b but with cross-section "i" 750 divided into subregions. The up-facing bounded subregions of cross-section "i" are labeled as 761, 764 and 768. The down-facing bounded subregions of cross-section "i" are 761, 762, and 769. The bounded subregions that are neither up-facing nor down-facing are 763, 765, and 767. The unbounded regions of cross-section "i" are subregions 766 and 770. It can be seen that subregion 761 is both up-facing and down-facing and thus it would generally be processed as a down-facing feature. If a cross-section "j" is above a completely unbounded cross-section, then all of cross-section "j" is a down-facing feature (e.g., the bottom of the part). If a cross-section "j" is below a completely unbounded cross-section, cross-section "j" is an up-facing feature (e.g. the top of the part).

Other definitions can be obtained as needed from remaining disclosure and the manuals attached as Appendices B and C to U.S. Patent Application SN 07/429,435, incorporated herein by reference. Moreover, the specifications of the SLA hardware, the resin and laser types, and the generally preferred parameters with respect to the stereolithographic processes described and improved upon herein are set forth in those Appendices.

## Preferred Methods of Obtaining Improved Structural Integrity

Several preferred embodiments of this invention relate to methods of obtaining improved structural integrity, lower post cure distortion, lower overall horizontal distortion, and in many cases overall lower vertical distortion (e.g. vertical curl) by effectively providing skin on more than just the up- and down-facing surfaces of the part being formed. For example, the effect of providing skin at only the up- and down-facing surfaces, and supplying cross hatch in x-z (X hatch) and y-z (Y hatch) planes, is to create an internal structure consisting essentially of relatively long columns of substantially untransformed material trapped by at least partially transformed crosshatch and boundary material on the sides and skin on the up-facing and down-facing surfaces. Accordingly, a leak in any portion of the down-facing or up-facing skin or cross hatch would have the potential to cause distortion and unwanted drainage of untransformed building material. However, if skin is provided in the x-y (horizontal) plane, at more than the up- and down-facing surfaces, then the compartments of untransformed material trapped by cross-hatch, boundary, and skin would be much smaller and better-contained. Other advantages emanating from providing additional skinned surfaces within the internal structure of the part can include improved structural integrity, less distortion during formation, reduced post-curing times, and reduced post-cure distortion. Additionally, surface finishing can be performed before post-curing, and in some circumstances, post curing can be completely avoided. There are various preferred embodiments that employ different approaches in obtaining this additional fill.

A first group of embodiments utilize exposures analogous to traditional skin filling techniques in that the fill is generated by a series of overlapping exposures. These embodiments may or may not employ the use of what is traditionally known as cross-hatch and fill in the same region of a cross-section.

In a first preferred embodiment an object is formed on a layer by layer basis initially by the exposure of building material to boundary vectors on a cross-section, followed by exposure of crosshatch vectors on the cross-section, and finally followed by exposure of skin fill vectors on any up-facing and down-facing regions on the cross-section. Additionally, on periodic or random (with a certain probability of occurrence) cross-sections even in non-down-facing and in non-up-facing regions skin fill vectors are provided and exposed. For example, at every 1/2 inch vertical interval through the part, which at 10 mil layers corresponds to every fifty layers, skin vectors are generated that provide for skinning of the entire cross-section. These skin vectors are provided in a form in which areas that are down facing can be distinguished from areas that are not down-facing so that different cure parameters can be used if necessary. It is possible to distinguish other regions but it has been found unnecessary to do so. The advantages of this approach have been previously described.

Of course other vertical spacing of skin fill is possible including geometry selective spacing. That is some geometric features may be better handled by one spacing of skins while others require a different spacing of skins. In this embodiment the boundary vectors and crosshatch vectors that are used to achieve adhesion between layers are generally given some overcure to insure adequate adhesion. However, the skin vectors that are used in non-downfacing regions can be given a cure depth that is less than, equal to, or greater than the layer thickness. It has generally been found that a skin depth greater than the layer thickness causes excessive curl and therefore isn't optimal. The skin vectors (combined with all other vector types) in a down facing region are, on the other hand given, only a one layer thickness cure depth. This embodiment can be combined in all, or in part, with the uniform skin thickness methods to be described hereinafter.

This method of building can be substantially implemented by Slicing the desired CAD object file, or the like, twice and then editing and merging the resulting .sli files together. The first slice is done with normal slicing parameters. For example by using X and 60/120 crosshatch with a 50 mil spacing and using X skin fill with a 3 mil spacing. The second slice is done without the use of skin fill but with the use of closely spaced crosshatch (which will function as skin fill) of type and spacing equivalent to the skin spacing of the first slice. For example, continuing with the previous example, the second slice would be done with the same layer thickness but with only X type crosshatch spaced at 3 mils. After creation of the second slice file, it is edited by hand or by a program that can go in and remove the skinning cross-hatch associated with the cross-sections not using fill in the non-down-facing and non-up-facing regions. Next the two files are merged together using merging options that keep all the vectors from the first slice and that keep only the remaining X layer crosshatch vectors from the second slice (all other vector types are removed including near-flat down-facing crosshatch). These hatch and fill vectors are still distinguished by block headers that indicate which merge object they came from. Therefore the combined file can be built as a single object.

One must be sure to give the proper exposure values to each vector type. Therefore, the hatch vectors from the second slice object are given associated exposure values equivalent to skin fill. This procedure will produce an object substantially like that described above. However, there are several differences between this implementation and that desired. First the regions of down-facing features and up-facing features might be given a double exposure (and therefore extra undesired cure depth) depending on whether the crosshatch from the second slice of the object is still included in the combined file or not. Second, since the present Slice program doesn't generally separate non-down facing hatch from down-facing hatch (except in the near-flat regions), there will be an additional cure in the down-facing regions since the crosshatch must be overcured somewhat to insure adhesion between cross-sections.

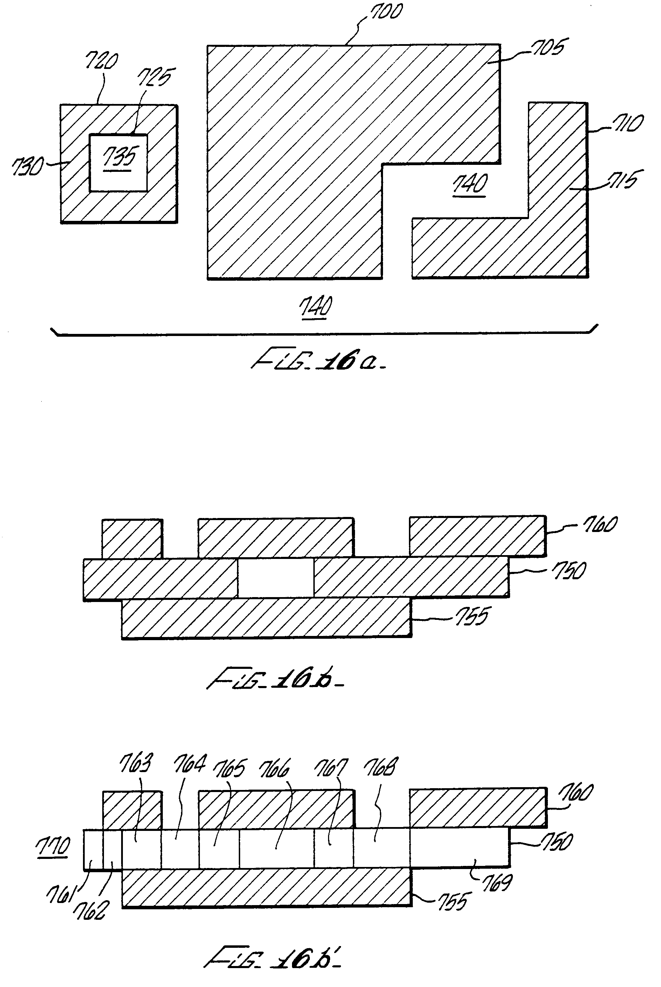

FIGURES 14a and 14b depict a side view of an object built according to the techniques of this first embodiment. FIGURE 14a represents a side view of the CAD designed object. The dotted regions indicate solid regions. FIGURE 14b represents a side view of the object as built according this first preferred embodiment wherein every third layer is skinned to help increase the structural integrity of the object. The regions labeled with forward slashes, "/", indicated regions that are skinned because they are down-facing. The regions labeled with back slashes, "\", indicate regions that are skinned because they are up-facing. The regions that are labeled with X's indicate regions that are to be skinned according to the teaching of the present embodiment that would not otherwise be skinned. Layers 1, 4, 7, and 10 are to be skinned according to this embodiment.

In a second preferred embodiment an object is built by providing and exposing boundary vectors on each layer, crosshatch on each layer and skin fill vectors on each portion of each layer. As with the previous embodiment and the following embodiments, this second embodiment is not restricted to part building with the use of vector data. The vector data is simply used as an implementation of the concepts of the invention and other methods of implementation could be used. Certain concepts of the invention deal with amount of solidification on each cross-section and/or the order of material solidification on each cross-section and/or the depth of solidification of each region on each cross-section. This second embodiment is similar to the first described embodiment except that now skin-fill is supplied on every region of every cross-section not just with down-facing features, up-facing features, and with periodic cross-sections. This second embodiment therefore results in green parts that have little or no substantially untransformed material trapped internal to their boundaries. There will be no substantially untransformed material if the effective skin depth thickness is equal to or greater than the layer thickness. There will be to a greater or lesser extent some substantially untransformed material if the effective skin cure depth is less than the layer thickness. As with the previous embodiment, it is desired to get some net overcure between regions of a cross-section that overlap with regions of the previous cross-section to insure adequate adhesion, but it is desired in down-facing regions that the net cure depth be uniform and be of only a one layer thickness cure depth. It has been found that with embodiments like the present one, where substantially all material on each cross-section is substantially transformed, that vertical curl can and generally does go up significantly but that horizontal distortion goes down significantly. It is known that the amount of curl (both horizontal and vertical) can vary tremendously depending on the amount of overcure between layers; the amount of overcure between adjacent lines on the same cross-section; the extent of the area over which the overcure takes place; the thickness of the layers; and the order of intercross-sectional solidification as well as the order of intracross-sectional solidification. If parts are to be built that contain few unsupported critical features, or in which the unsupported features can be supported by Webs, the direct application of this embodiment can lead to substantial improvements in part accuracy.

If the part to be built does contain critical regions that cannot be well supported then modifications to this embodiment can be helpful in reducing the vertical "curl" type distortion that may result. These modifications might include the use of the techniques of this embodiment (or "continuous skinning" or "skintinuous") on only the regions that are or can be adequately supported and continuing to use the standard building methods of boundaries, widely spaced crosshatch, down-facing feature skinning routines, and up-facing feature skinning routines on the other regions of the part. "Strongarm" building techniques can be effectively used in these other regions of the part. The result of this modified approach would be substantially increased horizontal accuracy in the supported regions with no sacrifice in vertical accuracy in the unsupported regions.

Other modifications, to avoid increased vertical distortion include the use of Smalleys, described in copending U.S. patent application 183,015; the use of Multipass drawing techniques, described in copending U.S. Patent Applications 182,823 and 339,246; the use of Rivet type layer to layer adhesion techniques, described in copending U.S. Patent applications 182,823 and 339,246; the use of "strongarm", "log jam", and "quilting"; as well as other techniques to be described hereinafter; and similar techniques; and combinations thereof.

As with the previously described first embodiment method of building, this method of building can be substantially implemented by Slicing the desired CAD object file, or the like, twice and then merging the files together. The first slice is done with relatively normal slicing parameters, except no skin fill is used. One example is by using X and 60/120 crosshatch with a 50 mil spacing. The second slice is done, again, without the use of skin fill but with the use of closely spaced crosshatch of type and spacing equivalent to that which is desired for forming skin fill on each layer. For example the second slice may be done with the same layer thickness but with only X type crosshatch spaced at 3 mil. After creation of the second slice file, the two files are merged together using merging options that keep all the vectors from the first slice (except any skin fill vectors that were used) and that keep only the X crosshatch (including near-flat down-

facing cross-hatch) from the second slice file (all other vector types are removed). The hatch from the first slice and the fill vectors from the second slice (actually hatch vectors from slice 2) are still distinguished by block headers that indicate which merge object they are from. Therefore the combined file can be built as a single object being sure to give the proper exposure values to each vector type. Therefore the hatch vectors from the second slice object are given associated exposure values equivalent to skin fill. This procedure will produce an object substantially like that described above as the preferred method of this embodiment. However, there is a difference between this implementation and the desired one described above. Since the present Slice program doesnt generally separate non-down facing hatch from down-facing hatch (except in the near-flat regions), there will probably be an additional cure in the down-facing regions since the crosshatch may need to be somewhat overcured to insure adhesion between cross-sections.

With the second embodiment and the first embodiment as well as with embodiments described hereinafter, there are many way to use the existing commercial software or to modify the outputs from the present commercial software to at least partially implement the various embodiments. The implementations herein are only meant to be examples of such techniques.

In a third preferred embodiment each cross-section is supplied with boundaries and skin fill vectors only (this embodiment does not utilize crosshatch. In this third embodiment the boundaries may be cured to an effective depth equal to the layer thickness or greater than the layer thickness depending on whether they are to be used to obtain adhesion with the previous cross-section or whether they are to be used to form a down-facing feature. As with the previous embodiment the skin vectors in non-down-facing regions may be cured to a depth less than, equal to, or greater than the layer thickness. It has been found that if skin vectors are cured to an effective depth greater than the layer thickness, by usual curing techniques, vertical curl will be greater. Therefore, if it is desired to cure the skin vectors to such a depth it is advisable to utilize a drawing method that will help to reduce curl, such as multipass. Multipass is a method of solidifying material in at least a two step process, wherein a first exposure of material to the synergistic stimulation leads to a depth of cure less than the layer thickness and the second pass (or higher order pass) results in a net cure depth that insures adhesion. Multipass is an effective way of reducing curl. An additional enhancement of multipass scanning is described in copending patent application 429,911 regarding the use of multiple wavelengths during the multiscanning process. A short penetration depth exposure is given on the first one or more passes to insure that substantial transformation of building material occurs prior to one or more additional exposures using long penetration depths that are used to obtain and insure adequate adhesion between cross-sections.

An additional problem that might occur with this third embodiment is that of excessive horizontal curl. In the previous embodiments horizontal curl was kept to a minimum by the exposing of cross-hatch prior to the exposing of skin, wherein the cross-hatch would act as a stabilizing frame upon which skin could be formed. Since this third embodiment doesn't contain cross-hatch it may be necessary to utilize a horizontal curl reduction technique also.

Such techniques include the use of nonconsecutive vector drawing, the use of non-overlapping fill vectors (e.g. "weave" which is the topic of embodiments to be described later), and the filling of non-consecutively drawn vectors by intermediate vectors (in many respects this is a horizontal version of the multipass technique described above). The non-consecutive ordering of vectors refers to a technique of supplying fill or hatch vectors with a particular spacing and then exposing the vectors in a nonconsecutive manner. In traditional stereolithography fill vectors are cured in a consecutive order.

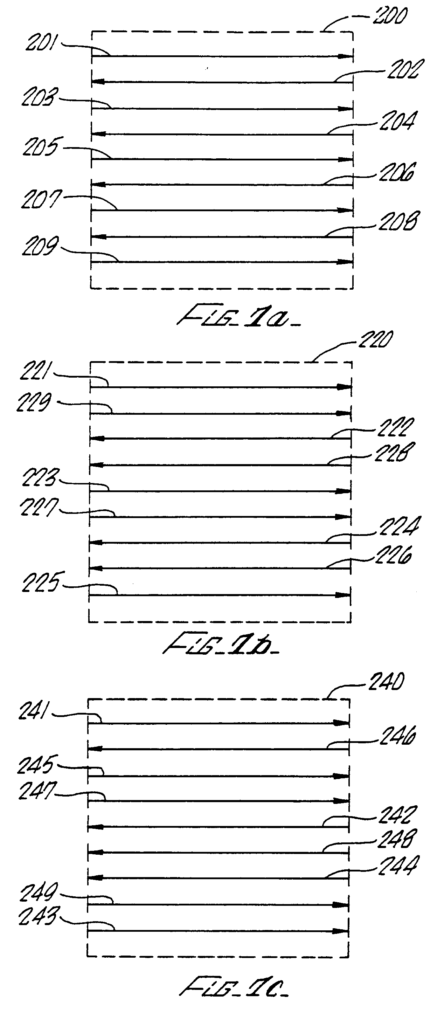

An example illustrating the differences between consecutive ordering and non-consecutive ordering is depicted in FIGURE 7. FIGURE 7a illustrates a cross-section of boundary 200 and containing unidirectional fill vectors 201 to 209. In traditional stereolithography the order of drawing is from vector 201 to vector 209. The direction of scanning each of these vectors has generally been such that the amount of jumping between vectors is minimized. The odd numbered vectors have generally been drawn from left to right and the even numbered vectors have been drawn from right to left. Therefore the entire fill can be drawn with minimal jumping between the head of one vector and the tail of the next.

FIGURE 7b illustrates a similar cross-section but wherein an example of nonconsecutive drawing order is used to minimize any horizontal curl that might have a tendency to occur. The cross-section is surrounded by boundary 220 and it is filled with vectors 221 to 229. The drawing order is from 221 to 229, therefore every other vector is skipped on a first pass of drawing and then the vectors skipped on the first pass are scanned on a second pass. This technique is especially useful for minimizing curl when two consecutively scanned vectors are separated by a distance so that the material cured by each vector individually doesn't connect to the material cured by the consecutively scanned vectors. Then on a second pass (or later pass) the gaps between the material exposed by the first pass are filled in by the additional pass which scans vectors intermediate to those of the first pass. If the width of cure of each vector is relatively wide compared to spacing between vectors it may be necessary to skip more than just every other vector. For example it may be necessary on a first pass to cure one vector and skip three vectors then cure another vector and skip the next three vectors, and so forth. On the second pass one may then cure the intermediate vector of each set of 3 vectors not drawn on the first pass, and then finally on a third pass the remaining unexposed vectors are scanned. This is illustrated in FIGURE 7c. The boundary 240 is filled with vectors 241 to 249 wherein the scanning order is 241 to 249.

If the skin vectors will only be given an effective cure depth less than or equal to the layer thickness it will likely be necessary to supply additional exposure in the form of point rivets, or the like, on the portion of the present cross-section that overlaps the previous cross-section. The proper use of rivets will lead to adequate adhesion between layers but will also tend to keep vertical curl to a minimum. As with the deeper cure depth methods this approach may also require the use of horizontal curl reduction techniques.

As with the previously described methods of building, this method of building can be substantially implemented by a user by Slicing the desired CAD object file, or the like, a single time. The part is sliced with cross-hatch but without skin vectors. The crosshatch vectors are spaced with a separation typical for skin fill. One or more crosshatch types may be simultaneously used. For example, one can use both X and Y hatch with a spacing of 0,102 mm (four mils) each. If the maximum cure width of cure for a single pass along one vector is equal to or greater than the spacing between vectors (e.g. 0,305 mm (12 mil) MCW) and one doesn't want consecutively cured vectors to effect one another then a drawing pattern similar to that described for FIGURE 7c can be used for each type of crosshatch. This procedure will produce an object substantially like that which would be produced by the preferred methods of the third embodiment. However, there is a difference between this implementation and the desired one described above. Since the present Slice program doesn't generally separate non-down facing hatch and boundaries from down-facing hatch (except in the near-flat regions) and boundaries, there will probably be an additional cure in the down-facing regions since the cross-hatch may be somewhat overcured to insure adhesion between cross-sections.

A fourth embodiment is similar to the third just described but it doesn't use boundary vectors either. Therefore, this embodiment supplies and exposes only fill type vectors. Since there are no boundaries associated with each cross-section in this embodiment, and therefore nothing other than surface tension and viscosity to hold the vectors in place as they are drawn except where there is horizontal contact to adjacent vectors and vertical contact with the previous cross-section, the vectors of this embodiment must be drawn in a highly ordered manner. The vectors must be drawn in an order and/or to a depth that assures adequate structural support to insure that each vector stays in place until the entire cross-section is drawn. If the vectors are drawn in an improper order then it is possible that some of them will drift out of position or be distorted out of position prior to the completion of the exposure and solidification of the cross-section. Since vertical curl generally occurs between material cured on the presently drawn cross-section and material cured on the previously drawn cross-section, vectors in this region can be drawn in a nonconsecutive order and can also be cured using two pass multipass to insure minimal curl. Subsequently, the vectors that occur in down-facing regions can be cured in a non-consecutive interlaced manner with vectors from the other hatch types. For example, one or more non-consecutive X type vectors can be scanned followed by the scanning of one or more Y type vectors and then repeating the exposure of other X type and Y type vectors until all the vectors have been scanned. In this region the direction of scanning can be just as important as the order of scanning. To insure the most appropriate positioning of vectors they may need to be scanned from the supported region towards the unsupported region.

Other embodiments, described hereinnext, create at least a substantial amount of fill on a cross-section in a manner more analogous to standard approach crosshatch vectors. That is by supplying and exposing vectors which are spaced such that they do not effect each other during their exposure. They are spaced at or slightly above the expected maximum cure width of the individually exposed vectors. Thereby, after exposure of all vectors a substantially transformed cross-section results with only minimal untransformed material between the vectors. The various embodiments of this approach are broadly known by the name "Weave".

The name "Weave" particularly applies to the first preferred embodiment of this concept (the fifth embodiment of this application). This embodiment is the presently most preferred embodiment of the various Skintinuous building techniques. This embodiment consists of supplying and exposing boundary vectors, next supplying and exposing at least two types of non-parallel cross-hatch, wherein the exposure of the first cross-hatch type is insufficient to produce a cure depth that results in enough adhesion to induce vertical curl to the previous cross-section and wherein the exposure of the second cross-hatch type is equivalent to the first type, thereby resulting in sufficient exposure in the overlapping regions to cause adhesion between cross-sections. The spacing of the crosshatch vectors is such that they are spaced slightly further apart than the maximum cure width of the individual vectors when given the appropriate exposure to result in the desired cure depth.

As with the previously described methods of building, this method of building can be substantially implemented by using SLA software to slice the desired CAD object file, or the like, a single time. The part is sliced with cross-hatch but without skin vectors. The crosshatch vectors are spaced with a separation slightly greater (e.g. 10%) than the expected maximum cure width. The presently preferred system for building parts using this embodiment is the SLA-250 manufactured by 3D Systems, Inc. of Valencia California. The presently preferred building material is XB 5081 stereolithographic resin (liquid photopolymer) manufactured by Ciba-Geigy. The presently preferred system utilizes a HeCd laser operating at 325 nm which typically results in a width of cure of approximately 10-11 mils or less for a cure depth of 8-9 mils. Therefore, the crosshatch vectors are spaced at approximately 12 mils. The presently preferred fill vectors are combined X and Y crosshatch. The presently preferred SLA software is version 3.60. When using the presently preferred software, an object is built by exposing boundary and hatch vectors. As stated earlier, adhesion between cross-sections is obtained at the intersection points between the two hatch types. The cure depth of these intersection points is approximately 12 mils when parts are built with 10 mil layers. This method of building results in substantially less horizontal distortion and equivalent or less vertical distortion than when equivalent parts are built with standard techniques. Measured post cure distortion is substantially less than for parts building using conventional methods.

The formation of a cross-section by this fifth embodiment is depicted in FIGURE 8a to 8i. FIGURE 8 represents a square cross-section which is to be cured to a uniform depth. FIGURE 8a depicts a top view of the material cured by scanning of the boundary vectors. FIGURE 8b depicts a sectional view of the material cured in FIGURE 8a along line b. The cure depth of the boundary vectors is the layer thickness plus some overcure amount (e.g. 0,254 mm (10 mil) layer thickness + 0.152 mm (6 mil) overcure). FIGURE 8c depicts a top view of the material cured in response to the scanning of the X cross-hatch on a dashed background of material cured in response to boundary vectors. FIGURE 8d depicts a section view of the material cured in FIGURE 8c along line d-d. The cure depth of the X crosshatch is less than one layer thickness (e.g. 0,203 mm (8 mil) cure depth for a 0,254 mm (10 mil) layer thickness). The exposed regions are relatively wide compared to the unexposed regions. That is, the spacing between hatch vectors was only slightly more than the maximum cure width of the hatch vectors (e.g. 0,305 mm (12 mil) spacing of hatch vectors and an 0,279 mm (11 mil) maximum cure width).

FIGURES 8e and 8f show similar cured material for Y crosshatch vectors. FIGURE 8g depicts a top view of the superposition of material cured as depicted in FIGURES 8a, 8c, and 8e. The small square zones in the FIGURE represent uncured material. The size of these squares is about 0,025 mm (1 mil) on edge or less whereas the solidified material between them is about 0,279 mm (11 mils) on edge. FIGURE 8h represents a side view of the cured shape of material along the line h-h of FIGURE 8g. Line h-h is directly above the maximum cure from an X hatch vector. FIGURE 8i represents a side view of the cured shape of material along line i-i of FIGURE 8g. The cure depth of the regions where the X and Y hatch vectors overlap has increased to something greater than the layer thickness. Line i-i is located between the cure of two adjacent X hatch vectors. Most of the area of the cross-section is more like FIGURE 8h than FIGURE 8i. The exposure in FIGURE 8h isn't uniform but the nonuniformity is less than that produced in the traditional approach to skinning a surface during part building. The main reason for this reduction is that there isn't a superposition of discrete hatch vectors with a 0,152 mm (six mil) over cure each which results in up to an 0,279 mm (11 mil) overcure, or more, at their intersection points combined with skin vectors that form a uniform layer thickness cure depth. Instead there is simply a double exposure of closely spaced hatch that produces a substantially uniform cure depth with points of approximately 0,127 mm (5 mil) overcure superimposed on it.

A variation of this fifth embodiment is to use weave in all non-down-facing regions and to use other more traditional approaches to skinning (including the uniform skinning methods described below) on the down facing features and to give these down-facing features a layer thickness cure depth.

A sixth embodiment of the present invention is similar to the fifth embodiment just described except in the sixth embodiment the crosshatch (or fill vectors) are offset or "staggered" from layer to layer. One implementation of this method is to offset the vectors on adjacent layers by 1/2 the hatch spacing. Therefore, the hatch vectors on every other layer overlay the same hatch paths. Other forms of layer to layer offset are possible wherein the overlaying of hatch paths (hatch paths are lines on a given cross-section that have the potential of being crosshatched) is repeated at some other period than on every other layer. For example hatch paths may not overlay each other for 3 or more layers.

Offset or "staggered" crosshatch may be utilized with standard building techniques as well as with the various embodiments of the present invention. The advantages of using offset crosshatch with standard building techniques (that is widely spaced hatch) involve the production of smoother vertical surfaces of an object, more uniform volumetric properties, and possibly less curl between layers since adhesion between layers is due to points instead of lines.

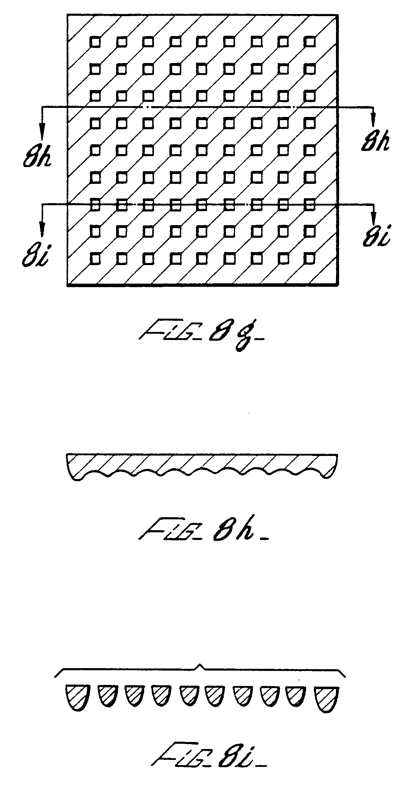

In building parts for investment casting, that hollow parts lead to less structural strain on the casting molds as the building material is burned away. Hollow parts can be built with crosshatch but without skins, thereby tending to allow untransformed material between the cross-hatches to drain from the object. Solid parts tend to expand and crack investment casting molds, whereas hollow parts have less of a tendency to do so. However, building hollow parts can be a problem even when skin fill isn't used if the hatch vectors on successive cross-sections lie on top of each other. Untransformed building material can be trapped between the cross-hatch and the boundaries which trapped material can later become solidified, thereby losing the desired hollow part characteristics of the object. However, if the centering-to-centering distance between crosshatch vectors is greater than approximately twice the cure maximum width, then offsetting the vectors by 1/2 the spacing on every other layer will result in a part where substantially all of the internally untransformed material can flow through various gaps and thus can be removed prior to using the part to make an investment casting mold. This advantage of offset crosshatch is illustrated in FIGURES 9a and 9b.

FIGURES 9a and 9b illustrate the sixth embodiment and depict side views of an object whose boundary vectors are offset from one another but are not offset sufficiently to allow drainage of untransformed material between them (these are nonvertical but steep boundaries as opposed to flat or near-flat boundaries). FIGURE 9a depicts a part built with overlaying crosshatch and therefore pockets of untransformed material trapped within it. FIGURE 9b depicts the part built with offset crosshatch therefore allowing pathways for removal of internal untransformed material. Assuming the top of each partial object reconverges so that building material cannot be removed from the top, as shown in FIGURE 9a, only pockets 306 and 308 can drain whereas 302, 304, 310, and 312 cannot drain. In FIGURE 9b, the entire internal area of the part forms one interconnected pocket from which substantially all untransformed material can drain. If using a photopolymer, drainage can be enhanced by utilizing elevated temperatures to reduce resin viscosity. Since a primary principle of the present invention is to solidify as much internal material as possible this sixth embodiment of offset crosshatch diverges from the skintinuous building techniques. But it is a useful building method in its own right. Its ability to reduce post cure distortion is discussed in Example 6.

Other embodiments of the nonoverlapping approach to building can be developed from appropriate combinations with techniques discussed in conjunction with overlapping exposure techniques as well as with the additional embodiments of the present invention to be described hereinafter.

Besides the two main approaches described previously, that is overlapping fill or non-overlapping fill on at least a portion of the cross-sections, there is an additional class of embodiments that is used to increase structural integrity. This next class of skintinuous embodiments is based on the curing of discrete points of material called "Bullets" instead of the curing of overlapping or non-overlapping lines of material. The bullets are cured in association with a single cross-section as a plurality of substantially nonoverlapping exposures. The embodiments of this approach comprise methods of solidifying primarily internal regions of objects whereas the down-facing and up-facing regions of the object may be cured by the other approaches described herein.

The seventh embodiment of Skintinuous (the first embodiment of this class) involves curing the internal portions of desired cross-sections by exposing material within the boundaries of the cross-sections as a series of discrete points. The points that are exposed on a given cross-section are spaced from each other by a distance slightly greater than the maximum diameter of the cured material formed upon exposure of the material to synergistic stimulation. In other words, on a single internal cross-section a substantial portion of the material is cured in the form of point exposures with a small gap separating each point exposure from its neighbors. This separation stops the transmission of stress and therefore diminishes curl. Each point is cured to a depth equal to or slightly greater than the layer thickness to insure adhesion between cross-sections. On the next cross-section the pattern of exposure is "staggered" or shifted so that the point exposures on this next cross-section are centered above the gaps between the points on the previous cross-section. This shifting pattern of bullet exposures is continued on alternating cross-sections until the desired region of the part is complete. This allows substantial structural integrity to be developed between cross-sections while decreasing the amount of curl when building with a given layer thickness.

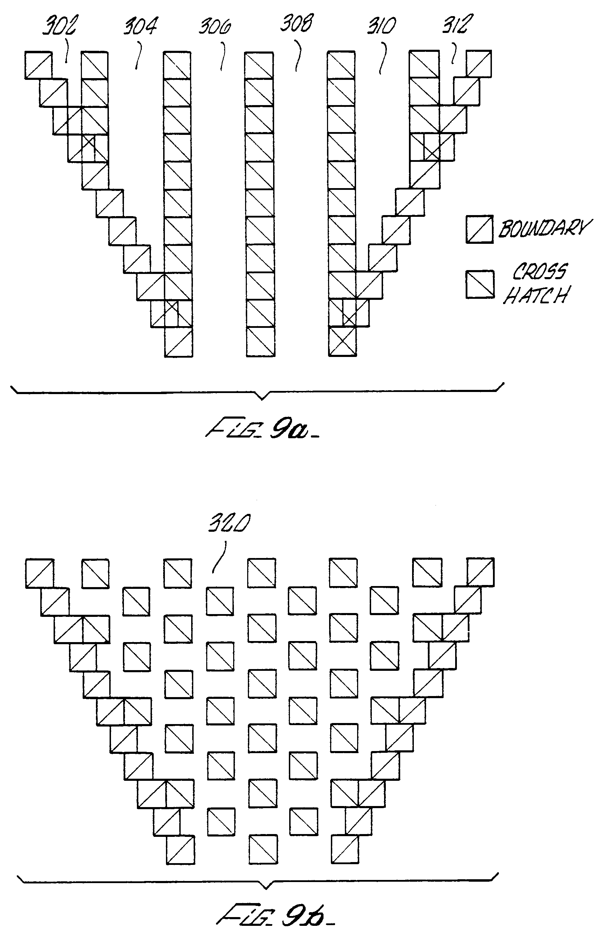

Two consecutive overlapping sample cross-sections are shown in FIGURES 10a and 10b. These sample cross-sections depict a cross-section boundary 400 enclosing a series of point exposures. FIGURE 10a depicts point exposures 402 located on a particular grid while FIGURE 10b depicts point exposures offset (staggered) from those in FIGURE 10a. A comparison of the two FIGURES indicates that the bullets on one cross-section are centered in the middle of the space between bullets on the previous cross-section. FIGURE 10c depicts substantially a side view of the combined FIGURES 10a and 10b along line c-c. This FIGURE, at least in a 2 dimensional view, illustrates how the bullets are staggered from layer to layer. The illustrations of FIGURE 10a and 10b depict a particular arrangement of points on a given cross-section but other arrangements are possible. For example to get a tighter fit of bullets (higher ratio of transformed to untransformed material on a given cross-section) one could locate the points in a hexagonal pattern. This hexagonal pattern when combined with higher cross-sections could form a hexagonal close-pack structure. Therefore each bullet would have 6 nearest neighbors on the cross-section as opposed to only 4 as shown in FIGURES 10a and 10b.

This method of building with bullets can only be partially implemented from present 3D Systems software. This implementation is only partially satisfactory. Proper utilization of this embodiment requires modified software.

The implementation from the present software is done by slicing the object with a single type of crosshatch vectors (e.g. X vectors) with a spacing slightly larger than the diameter of the bullets of material that will be formed. The object is sliced a second time with the part offset by 1/2 the spacing along the direction perpendicular to the chosen crosshatch direction (e.g. the Y-axis). The two objects are merged together using options that shift the second file by -1/2 the crosshatch spacing along the perpendicular direction (e.g. Y-axis) and 1/2 the crosshatch spacing along the X-axis. Also the merging options used remove all the vectors from the second slice file except for the cross-hatch vectors. Then the resulting file is edited to remove the hatch vectors from alternating slice files on alternating layers.

When vectors are cured using the present software they are not cured by a continuously sweeping beam but by a beam that jumps a small distance (e.g. integer multiples of 7,62 $\mu$m (0.3 mils)) known as the stepsize or SS, and then it waits at each allowed SS position a period of time known as the step period or SP (e.g. integer multiples of 10 microseconds). The particular positioning for both timing and jumping is based on the beginning point of each vector that is drawn. When the object is built, the SS value used is equivalent to the spacing between vectors (e.g. 0,305 (12 mils or approximately an SS value of 40). Since the two files were offset when they were sliced along the direction perpendicular to the hatch direction and then shifted back together during merge, the Y-value associated with each bullet will be offset by 1/2 the crosshatch spacing on alternating layers. Since the files were merged then offset from each other by 1/2 the cross-hatch spacing along the direction of the crosshatch the X-value associated with each component will be offset by 1/2 the crosshatch spacing between alternating layers.

This method of implementation is useable but not always satisfactory since in some of the extreme values, the X-component of each vector fall slightly (1/2 the crosshatch spacing) outside the boundary of the cross-section. Other software based methods of implementation using the present software are based on slicing the part twice as described above but here each part is sliced with a layer thickness twice as large as desired and one of the parts is shifted by 1/2 the layer thickness prior to slicing and then shifted back during merging.

A useful tool for implementing this embodiment from the present software without a major change would be to include a parameter that would allow crosshatch vectors to be reduced in length at each end by a specified amount. This would allow shifting along the direction perpendicular to the hatching direction, along with the reduction of the vectors created by the second slice by 1/2 the crosshatch spacing, followed by the reregistration of the files during merging. Also of use would be an editing program that could read through the merged file and remove selected vector types from appropriate cross-sections.

If one is building an object with an orientation that is substantially more susceptible to curl than the perpendicular orientation, this embodiment may be modified to that of an embodiment of offset unidirectional crosshatch. Here the direction of offsetting would be the direction most susceptible to curl and the direction of the vectors would be the less susceptible direction.

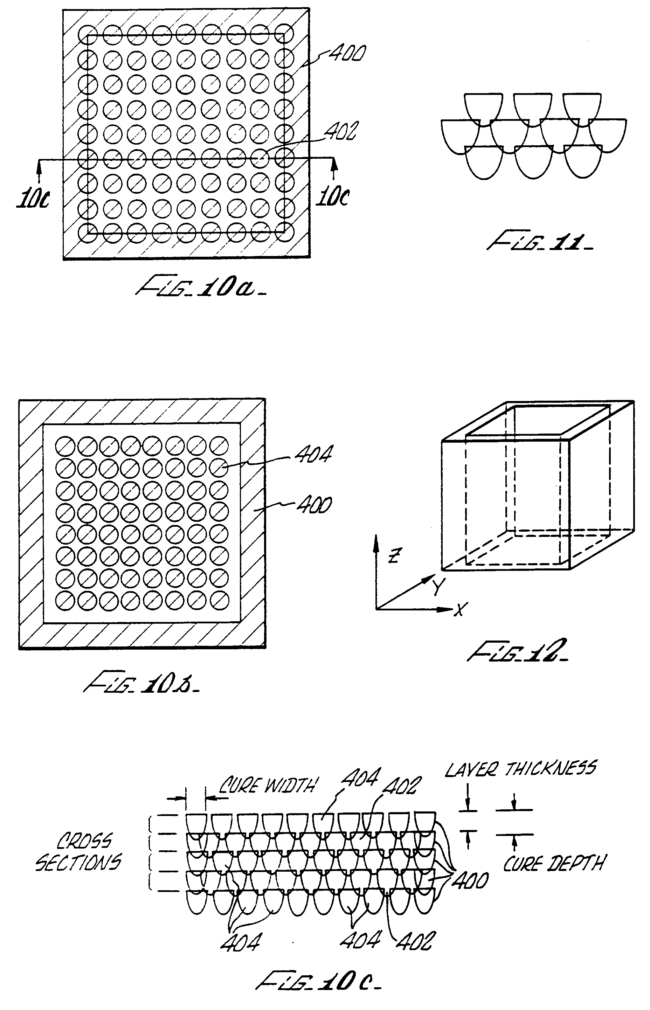

The eighth embodiment of the present invention is similar to the seventh embodiment but the bullet's are cured so as to solidify material in association with the previous cross-section as well as the present cross-section. Therefore the cure depth of each bullet is typically equal to or somewhat larger than two layer thicknesses. Accordingly, in this embodiment, it is important, when working with a particular cross-section, to know not only the internal regions of the present cross-section but to also know the internal overlapping regions of the previous cross-section. The spacing of the bullets is somewhere between what it was in the previous embodiment and the diameter of the bullet at one layer thickness below the present cross-section. The adhesion between layers is gained substantially by adhesion between the sides of the bullets on the present cross-section at a position one layer thickness below their upper surface and the sides of the bullets on the previous cross-section at their upper surface. A side view of the bullet positions on adjoining layers is depicted in FIGURE 11. It is noted that the present embodiment is primarily for regions of the object two or more layers from down facing features.

In still other embodiments, transformation of material that is located on one cross-section may occur from exposures given in association cross-sections two or more layers higher up.

As discussed above, several new skinning techniques can advantageously be used in connection with this invention, based on non-consecutive ordering of skin vectors. Traditionally, skin vectors are ordered head-to-tail, such that a first vector pass is made along a fill path from one boundary to an opposing boundary, and a pass along the next vector is then made, slightly offset (e.g., typically from 0.025 to 0.1 mm (1 to 4 mils) from the first), from the latter boundary back to the first. However, it has been found, in accordance with some of the preferred embodiments of this invention, that distortion can be reduced by appropriate, non-consecutive scanning and therefore nonconsecutive formation order of skin fill . Specifically, the offset between vectors can be advantageously increased (e.g., doubled or tripled, or more), such that the successive skin vectors have less impact, or do not impact, upon adjacent lines of cured building material for a given series of passes across the surface of the region of the part being formed. Additionally, in one or more successive series of passes, additional skin vectors can be drawn between those that had been drawn in the earlier series of passes. These embodiments preferably have crosshatch vectors on each layer as well as skin vectors.

Yet another embodiment according to which distortion can be minimized involves skinning in different directions for different layers. For example, in a part having x- and y- hatch on each layer, odd layers can be skinned in the x-direction and even layers in the y-direction, or vice versa.

In still another embodiment, skin fill can be provided in both x- and y- directions on a given layer having x- and y- crosshatch.

According to a most preferred embodiment, however, x, 60° and 120° cross-hatch is provided with skin fill in at least one of the x, 60°, or 120° directions, and preferably, in each of the directions. In a preferred variation of this embodiment, discussed in more detail below, the skin vectors of a given direction are not traced directly over the hatch vectors of the same direction, thereby avoiding excess exposure to any given location. Moreover, since exposure is provided in three directions over any given point in a skinned layer, the vector scanning speed can be increased by a factor of three to yield one-third of a normal exposure per vector, resulting in a uniform exposure after all three directional passes are made.

Another embodiment is that of "tiling". In this embodiment one of the previously mentioned approaches is utilized in exposing individual "tile-like" regions wherein small spacings of material between the individual tiles are left untransformed to act as stress relief zones. The size of the individual tiles can range from that of a point exposure to that of an entire cross-section, with the most preferable size range between 6.35 mm (1/4 of an inch) on edge to 19.05 mm (3/4 of an inch) on edge.

Tiling is a method of forming a layer of an object produced by stereolithography, wherein the layer is divided into a series of area elements or tiles. Each area element is isolated from adjacent area elements by spacings. The spacings around each area element remain untransformed, at least until all neighboring area elements or tiles are transformed or solidified. The spacings between the individual tiles are left untransformed to act as stress relief zones. The width of the spacing is typically small compared to the width of the individual tiles.

Tiling can also be used as another technique of curl reduction when implemented on a second or higher layer above a down-facing feature. Generally no curl is generated on a down-facing feature so there is no need for tiling as a curl reduction technique on a down-facing feature. It should also be noted that tiling does not generally apply to down-facing features because there is no underlying structure to attach individual tiles to during the transformation process, i.e., tiling may be applied only to a supported area as opposed to an unsupported area.

Since the tiles are individual and discreet relatively small areas, the use of tiles limits shrinkage to the boundary of the tile. This reduces stress and curl on the tiled layer, an especially important consideration in the first few layers immediately above a down-facing feature. Curl generally occurs mainly in down-facing features. These features curl upwardly as a result of the formation of the next several overlying layers. On the other hand, a potential disadvantage of tiling is that it possibly provides less strength.

The spacings in between the tiles can be transformed or solidified (referred to as grouting or mortar) usually after all of the tiles have been formed. An entire object can be made by tiling to reduce post treating. This grouting is usually transformed to a lesser degree than the tiles (a lower exposure is used).

By way of example, when using a presently preferred material such as XB5081 and 0.125 mm (5 mil) layers, tiling may be used in forming the first through twentieth layers above a first layer of a down-facing feature and especially to form layers through 10 (assuming the first layer is supported). If 0.254 mm (10 mil) layers are used, tiling would preferably be applied in the range of the 1st through 10th layer and especially in the 1st through 5th layer above a down-facing feature.

Preferably, the tile sizes range from the width of a laser beam about 0.254 mm (about 0.010 inches), up to about 3.048 - 3.81 mm (0.120-0.150 inch), with the most preferred range being from 3/4-2 millimeters on edge.

The spacings or gaps in between the tiles should be as small as possible, within the limits of accuracy of placement and cure width of a beam of synergistic stimulation. The typical width of these gaps is in the range of 0.025 - 0.25 mm (1-10 mils) after exposure and cure. It is important that the material in the spacings or gaps not be transformed or solidified sufficiently to transmit stress.

Where a scanning mirror-directed laser beam is used to transform the material, the "jumping" speed from tile to tile across the spacings must be considered. The mirror(s) directing the laser has a moment of inertia which limits its rate of angular acceleration. If the laser is to jump from the edge of one tile to the adjacent edge of another tile, the jumping speed is limited since there is only a very small distance in which the mirror can accelerate before it must begin to decelerate to properly direct the laser onto the edge of the next adjacent tile. Since the jumping speed is limited, the material in the gap may be inadvertently partially cured by the jumping laser. In tiling methods wherein the laser is frequently jumping back and forth between tiles, this can become especially problematic.

Inadvertent curing of the material in the gaps during tile jumping between tiles can be overcome in several ways. The mirrors can be made to accelerate faster, although a practical upper limit is quickly reached. Alternatively, a shutter can be provided to both the laser beam before reaching the scanning mirror. However, mechanical shutters also suffer from inertial lag and are considered too slow to be effective. Electrically driven crystal acousto-optic shutters can be considered. A third technique, i.e., the "long jump" technique is the most preferable. In the long jump technique, the laser is jumped from a far edge of a tile accelerating over the tile (the launch tile) then crossing the gap at maximum velocity to a distant point on the adjacent tile (the landing tile) decelerating and beginning to transform the area of the tile near its far edge. By making the long jump, the laser has a sufficient distance in which to accelerate such that it passes over the gap at a high speed and decelerates to the landing point distant from the gap.

Tiles can be formed in various patterns and shapes. One basic way is to form square or rectangular tiles in a straight grid pattern, i.e., with the gaps or grout lines extending continuously in the two directions of the layer (x and y directions). However, with this grid pattern, the grout lines themselves are relatively long lengths of material which when cured are subject to curling. Moreover, the tiles forming the simple grid pattern are not structured to resist curling in either direction caused by shrinkage of the grout lines during curing. Thus, the straight grid tile pattern has two axes of weakness.

An improved tile pattern is an offset or staggered grid wherein the tiles are staggered in alternate rows, like bricks in a horizontal wall. With the tiles in this staggered grid pattern, the grout lines extend continuously only in one axis, rather than in two axes as with the straight grid pattern described above. In addition, in the staggered grid pattern, the grout lines meet only at "three-way" intersections rather than four-way intersections as in the straight grid pattern. Consequently, the grout lines can shrink from only one direction as the tiles block off shrinkage from one side. The staggered grid pattern has only one "weak axis" i.e., along the uninterrupted grout lines, whereas the straight grid pattern has two weak axes. The tiles in the staggered grid pattern reduce curl and also make a stronger layer by distributing weak points.

The relatively long grout lines extending in a single direction in the staggered grid pattern can shrink substantially but still cannot cause the plane of the layer to bend upwardly, as the alternating tiles are able to resist bending.

As the building material is cured, using preferred materials (XB 5081), there is a delay of approximately 2-3 seconds prior to shrinkage of the material. Consequently, if no grout is used, the tiles can be formed as fast as possible. However, in embodiments which include grout, the tiles must be cured first and allowed to shrink (for a few seconds) prior to laying grout. Tiles can be cured by skinning. This skinning can be formed using multi-pass, weave, rivets, as well as other techniques discussed previously or discussed in previously incorporated applications. These curl reduction techniques allow the tiles to be larger in size without incurring significant curl. The tiles can be cured by providing skin fill over the entire tile surface and then moving on to the next tile. Alternatively, the tiles can be partially cured (e.g., a one line trace) followed by partial curing of other tiles, and then returning one or more times to fully cure the previously partially cured tiles.

In the staggered grid pattern, curing of the grout lines extending unbroken in the x direction also causes shrinkage in the y direction inducing some amount of y direction curl.

Triangles are another pattern shape which can be used in tiling. These patterns can be replicating triangle patterns using a single triangle size and shape, or a replicating pattern using triangles of different shapes. In addition, patterns of random triangles can also be used, so long as adjacent edges match to create an acceptably narrow gap. With patterns of random triangles, the grout lines can all be made short and interrupted so as not to create any weak axes.

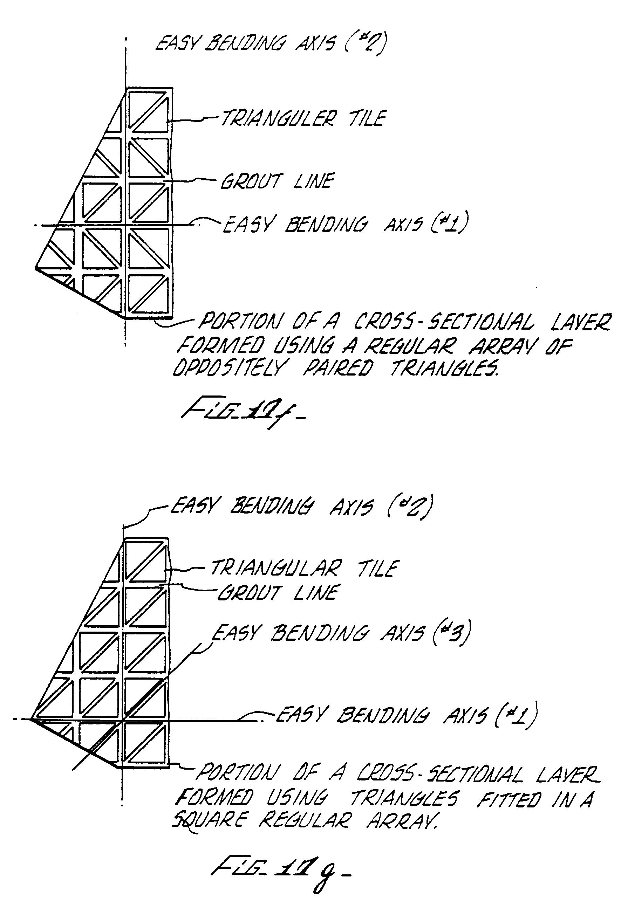

The hexagon is the most preferable tile shape. Hexagons can be closed packed to form solid tiles separated by thin isolating lines. A pattern of hexagon tiles has no weak axis and no long grout lines. Following the hexagon tile pattern (Figure 17a) in declining order of preference are random order and size triangles (Figure 17b), higher order triangles (Figure 17c), staggered grid square tile patterns (brick wall) (Figure 17d), straight grid tile patterns (Figure 17e), square regular array oppositely paired triangles (Figure 17f) and square array regular triangle patterns (Figure 17g). Other patterns besides those depicted in Figures 17a-g exist which lead to regions of reasonably isotropic cure and no weak axis planes (e.g. regions fitted by two or types of polygons or close packed circular tiles.

In forming layers with tiling, it is preferable to stagger the tile positions from layer to layer, such that the tiles and adjacent layers do not align with each other. Offsetting tiles between layers improves strength without unduly increasing curl. Tiles that are aligned or non-staggered from layer to layer, (i.e., columns of tiles) may be acceptable for tiling in the first few layers above a down-facing feature. Followed by conversion to a method of building that connects the isolated tile regions together. However, if an entire object (excluding a down-facing portions of layer) is built with tiling, staggering of tiles between layers is desirable. The stagger can be intermittent, i.e., with groupings of short columns of tiles throughout the object. If grouting is provided, staggering of tiles between layers may not be required for strength, but may be preferable for homogeneity.

Additional disclosure useful for implementing tiling is set forth in U.S. Patent Application, Serial No. 07/606,191, entitled Boolean Layer Comparison Slice, filed by Snead et al, which application is incorporated herein by reference. This application discloses use of a across-sectional comparisons to determine down-facing and other features associated with each cross-section. These techniques can readily be extended to determine areas to be tiled. These areas to be tiled may include regions which are 1 or more layers above down-facing features. The most preferred method of implementing tiling, as well as other skintinuous methods disclosed herein, is through deviations between the object design or desired objection design and the building representation, where these deviations are incorporated by a slice type program. The modifications to the slice program for implementing tiling can include utilization of sets of alternating closely spaced and further spaced hacth paths. The area between the closely spaced paths determines the grouting or gap regions whereas the area between the further spaced paths determines the areas to be filed. A second preferred method is by formation of a vector set of skinning vectors which are continuous across the region which can be broken down into portions of vectors to be cured and portions to be left uncured. This process of determining portions for curing and portions for not curing can be made in the process computer as part of a build program or the like. Of course, other methods of implementation exist.

A main thrust of several of the above mentioned embodiments is achieving maximum solidification with minimum distortion prior to attachment of adjacent layers. Complete unattachment for too long a period of time can lead to drifting of solidified material out of it designated position. One method of maintaining the positioning of floating solidified material without inducing curl into a preceding layer is to attach only one point of each vector (e.g. each hatch vector of the first pass of hatch when using the weave approach) to the preceding layer (which will tend to fix the vector in place). Then the one point anchored vectors, which have been floating, are scanned an additional pass to complete the curing process and to insure adequate adhesion between boundaries and hatch.

Generically, multiscan techniques can be used with many of the above embodiments to help reduce curl. The multiscan may be done in the form of multiple passes over individual vectors or it may be done by crossing of vectors or by riveting areas together, or the like.

The use of Smalley's and other curl reduction techniques may also be readily used in conjunction with many of the above embodiments to reduce various distortions.

An additional approach to minimizing curl in the various skintinuous embodiments is called "Strong Arm". In this approach the first layer of an unsupported region is given extra cure to make it stronger and therefore better able to resist the curl that the weaker, thinner upper layers will attempt to induce in it.

Other distortion reduction techniques defined in the definition section of this application can also be used.

## Preferred Methods of Obtaining Uniform Exposure

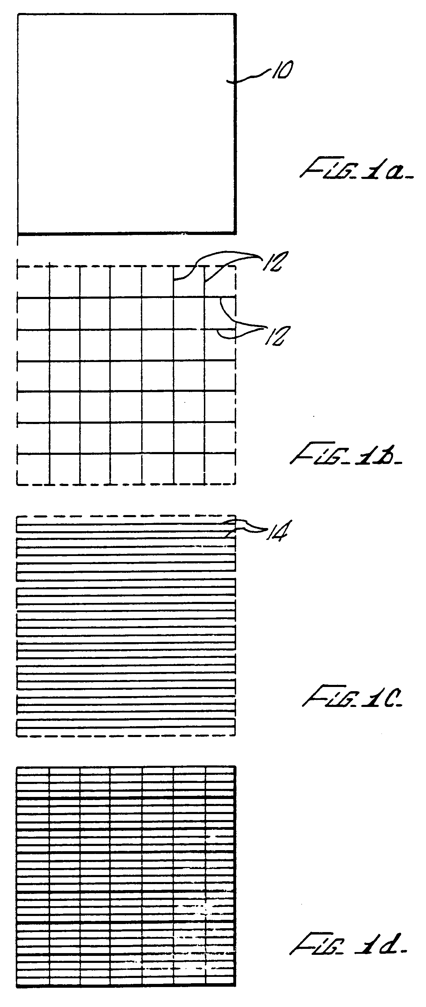

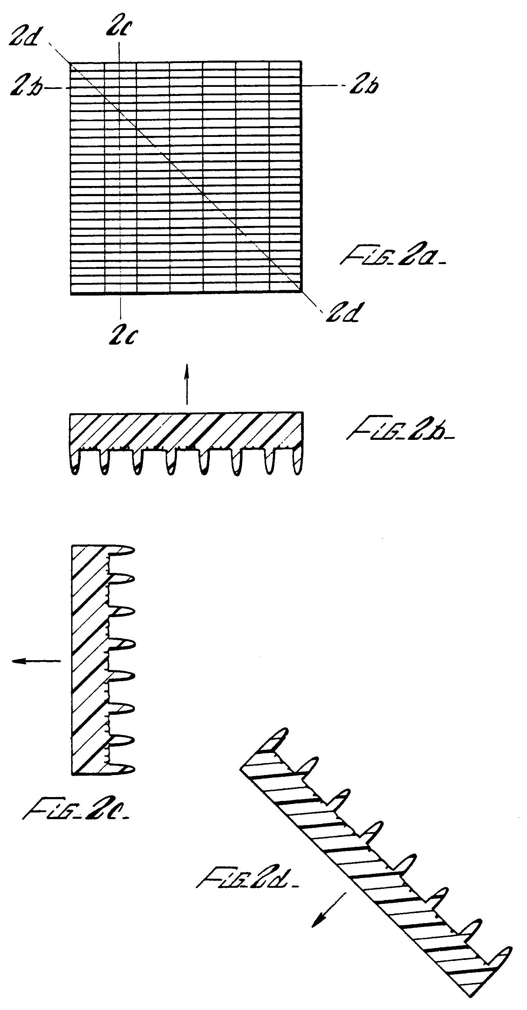

Turning to FIGURES 1 and 2, it will be seen that multiple exposure of boundaries 10, hatch lines 12, and skin fill 14 will likely cause cure depth variations as depicted in FIGURE. 2.

To obtain a smooth down-facing region, the net exposure over all the area elements must be the same. While uniform cure depth is necessary for smooth down-facing features, it is not necessary to achieve smooth up-facing features. These up-facing features attain their smooth surface finish from the smoothness of the building material working surface (e.g. resin surface), and from adequate strength of skins preventing their collapse from various forces including shrinkage during post-curing.

There are three main approaches that are exemplified herein to attain uniform exposure, particularly of down-facing regions. While the third approach is most preferred, the other two are within the scope of the invention, as are variations of all three that will be apparent to one of ordinary skill in the art in light of the following description.

A first approach to avoid differential exposure is to avoid the use of both boundary and hatch vectors, and only use fill vectors to cure down-facing regions, using uniformly exposed skin fill that results in an appropriate skin depth. This is a viable method of obtaining uniform exposure and therefore cure depth, but can suffer from distortion problems, as a relatively rigid frame (boundary and cross-hatch) is generally required to keep the skin from distorting as it is drawn. As described previously, if special attention is paid to the drawing order of the vectors, this method can be made viable.

A second approach is to draw boundary and modified hatch vectors to the full desired depth. First, hatch vectors must not be permitted to cross other hatch or boundary vectors to avoid extra depth being added to these solidified crossover regions. The remaining pockets are filled in with small skin fill vectors that do not cross any of the cured boundary or hatch lines.

This second approach can be implemented, for example, by either of two methods.

The first method is based on a single direction of hatch being drawn as uninterrupted vectors with hatch that runs in other directions "jumping" the points where they cross the first hatch type and where they cross each other. These hatch vectors are broken into their required components and stored in an output file for controlling the movement of the scanning mirrors (sometimes referred to as an .SLI file). In addition to hatch vectors that are drawn part of the time and jump the other part of the time, individual skin fill vectors can be created to fill each pocket that is formed by intersecting hatch and/or boundary vectors. These fill vectors are stored in the .SLI file.

The second method is based on standard hatch and skin fill vectors being stored in the SLI file along with a system (e.g., as part of the mirror driving system) that uses slice, beam profile, vector intersect direction, and cure depth parameters to break down vectors into drawing and jumping elements depending on whether they cross a hatch vector, boundary vector, or whether a hatch vector is underneath the vectors being analyzed.

These two methods falling within the second approach require definition of what it means for hatch and skin fill vectors to cross or lay on top of hatch or boundary vectors. This definition can be based on a determination of how closely an exposed vector (both skin and hatch) can approach a hatch or boundary vector without causing an increase in maximum cure depth in that region.

The first method of this second approach may result in creating large .SLI files and large associated vector loading times. Accordingly, the second method of the second approach is currently more preferred, when used in conjunction with a look-up table. The contents of such a table in each instance will vary, depending upon the slice parameters used, beam profile characteristics, and desired cure depth to be obtained, and can be routinely formulated for any required set of parameters by one of ordinary skill in the art. This system can optionally be adapted to account for approach angles between vectors.

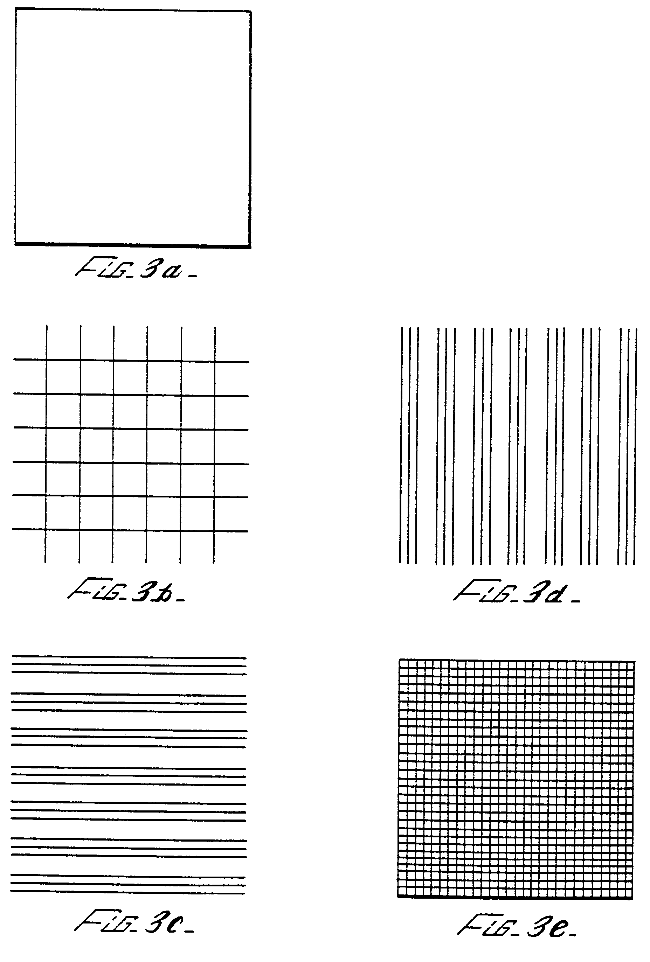

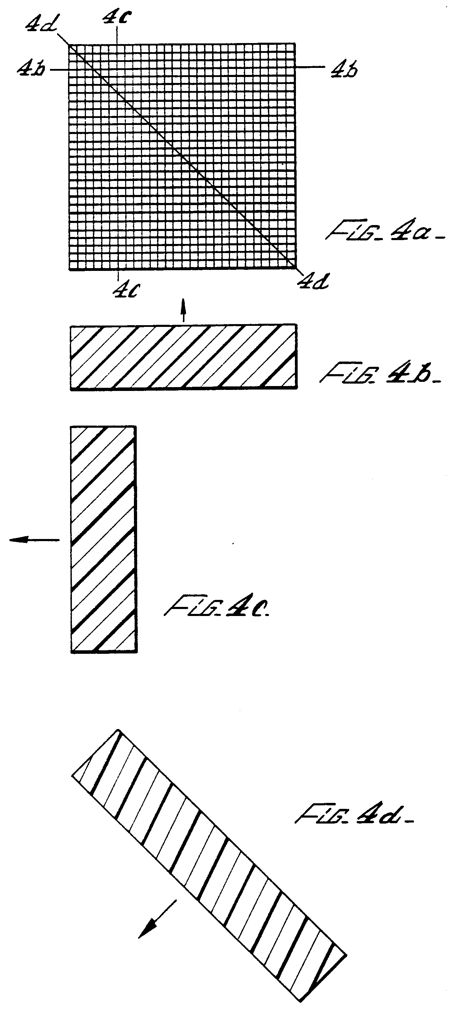

The third, and currently most preferred, approach is based upon matching skin parameters to hatch parameters, to avoid duplicate exposure by skin vectors of regions cured by hatch vectors. The duplicate exposure could result from skin vectors running parallel or antiparallel to the hatch vector regions. This approach differs from the above-described approaches in that the skin vectors are drawn over the cross-hatch, giving additional exposure to hatch vectors that are not parallel to the skin vectors as drawn. This continuation of skin fill vectors will keep the .SLI file size from becoming too long. This approach is collectively illustrated in FIGURE 3. It will be noted that the skin fill in FIGURES 3c and 3d is discontinuous in areas corresponding to the x- and y- hatch running parallel thereto. The uniformity of the resulting cure depth is illustrated in FIGURE 4.

A down-facing skin area, or "region," can be divided into categories or "subregions," based upon the nature of the exposure, i,e., whether and to what extent there is overlap between different vector exposures, as follows:

   subregion 1 -- skin exposure only;
   subregion 2 -- skin and hatch overlapping exposure;
   subregion 3 -- skin and boundary overlapping exposure;
   subregion 4 -- hatch and boundary overlapping exposure;
   and subregion 5 -- skin, hatch and boundary overlapping exposure.

Several approaches are suitable for exposing subregions 1 through 5 such that each region will be given the same net exposure. In the presently most preferred embodiments, three criteria are paramount.

First, to provide a suitably rigid frame to support the skin fill, the following drawing order is preferred: first, boundary vectors, then hatch vectors, and finally fill vectors are drawn.

Second, the fill vectors and the hatch vectors preferably begin and end short of the boundary vectors by 1/2 the ECW of the boundary vectors (taking into account the angle of approach). This reduces subregions 3, 4, and 5 to regions that contain boundary vectors only, such that the boundary vectors should be given the full exposure required in order to attain the desired cure depth.

Finally, a set of fill vectors are preferably drawn parallel to each type of hatch vector used, and all fill vector types are preferably given the same exposure, with the exception that fill vectors should not be allowed to contribute to further exposure in the regions exposed by their parallel hatch type. For example, if x- and y- hatch are used, then x- and y- fill are also used. Also x- fill vectors will only be created that are spaced at least 1/2 the ECW of the hatch lines away from the x-hatch vectors. A similar relationship should be maintained for y- fill and y- hatch.

This means that subregion 1 will have an exposure equivalent to the combined exposure of each fill type. Using the same example of x- and y- hatch and fill, each fill type should be exposed to 1/2 the exposure required to obtain the desired cure depth. Limiting fill vector exposure in this manner has a profound effect on subregion 2, which can be considered to consist of two microregions: a) a microregion containing overlapping of the various hatch types as well as the various fill types, and b) a microregion containing a single hatch type and the various fill types. Fill vectors will be absent from this first microregion since they have been excluded to avoid re-exposing hatched areas. Accordingly, the first microregion receives its total exposure from that of the combined hatch types. Thus, for x- and y- hatch, each hatch type will contribute 1/2 the needed exposure. For the second microregion, part of the exposure will be provided by the single hatch line, and the remainder by fill types that are nonparallel to it. This results in the total exposure being given by the exposure of one hatch line plus the exposure from all but one of the skin types. Therefore, the number of exposure sources is equal to the number of cross hatch types, and hence, to the number of skin fill types. Using x- and y- hatch, for example, 1/2 the exposure in a region of x- hatch is provided by this hatch and the other 1/2 is provided from the y- fill and vice-a-versa.

This most preferred approach can be summarized as follows: The preferred curing order begins with boundary vectors, followed by hatch vectors, and finally by fill vectors. The boundary vectors provide the desired cure depth. The skin and hatch vectors are shortened due to the ECW of the boundaries (shortened by the EEP). The fill vectors are not allowed to contribute to the exposure (be created) within 1/2 the ECW of either side of a parallel hatch vector. Each combination of hatch type with its parallel skin type is used to achieve a uniform cure depth. Each hatch vector and net exposure of its corresponding fill type is given the same exposure. Therefore, the individual fractional exposure (IFE), a dimensionless fraction of the needed exposure, given to each type is the reciprocal of the number of different hatch types (NHT), i.e.,

$$IFE = 1 / NHT.$$

A preferred embodiment of the above is based on the use of the presently preferred cross hatching method. This preferred hatching technique utilizes x and 60/120 hatch instead of x- and y- hatch. While the foregoing discussion relates to general preferred methods of reducing "waffle" appearance, it is most preferred to use this method of waffle reduction/removal in connection with these presently preferred hatch types, i.e., equally-spaced x, 60° and 120° hatch. The resulting hatch vectors form equilateral triangles. Accordingly, there will be regions where there is one hatch vector, and regions where three hatch vectors overlap, but never, assuming accurate scanning, regions where only two vectors overlap. The corresponding skin fill will be in the X, 60°, and 120° directions. These fill vectors will again not be allowed to produce additional exposure within the 1/2 the ECW of either side of their parallel hatch vectors and within 1/2 the ECW (taking into the angle of incident) of the boundary vectors. The order of curing will again be boundaries first then hatch and then fill. The boundaries will be given a full exposure to bring them to the desired cure depth. The hatch and fill vectors will again be shortened on each end by the EEP of the boundary vectors. The hatch vectors will each be given 1/3 the required exposure necessary to achieve the final desired cure depth. The fill vectors will be scanned such that the net exposure in the "skin only" region will also be given by 1/3 of this exposure.

Except in regions of boundary vectors, to reach full exposure, each point must be scanned by three vector types of 1/3 exposure from each type. In the region of skin alone, if all three skin types of equal (1/3) and overlapping exposure are used, a net exposure of 1 will be attained. Similarly, for a region of hatch and skin, one hatch type is used, along with the two skin types not parallel to it. Each is given an equal exposure of 1/3 to obtain a region of net exposure 1. If the hatch vectors form equilateral triangles, it follows that each time any two hatch vectors overlap, the third hatch vector will also be present. If each hatch vector is given an exposure of 1/3, then the net exposure in this region will be 1.

In regions where boundaries occur, an imbalanced situation exists due to the presence of a boundary vector as well as the other vector types described above. The possibilities include the presence of: 1 boundary + 3 hatch vectors; 1 boundary + 1 hatch + 2 fill vectors; or 1 boundary + 3 skin vectors. These combinations can be addressed, for example, in one of two ways: 1) have all hatch and fill vectors stop short of the boundary (at 1/2 the effective cure width) and then give the boundary itself an exposure of one; or 2) select two of the hatch types and the same two skin types to cure completely up to the boundary and stop the other hatch and skin type short of the boundary at 1/2 the ECW of the boundary. If the boundary vectors are given a 1/3 cure, as are the other vectors, this combination results in a net exposure of 1 in the boundary region. The first of the above two options is presently the most preferred.

Yet another embodiment is based on the use of x and y hatch along with the second option described above. In this case, the exposure in the boundary region would be due to the boundary vectors, one hatch and its corresponding fill type with the other hatch and fill type stopping short. This embodiment has the advantage of insuring better adhesion between the boundary vectors and the fill and hatch vectors.

Still another embodiment is based on the use of x and 60/120 hatch along with the net exposure in the boundary areas being made up of exposing boundary vectors along with exposing two of the three types of hatch and the corresponding fill vectors.

Other additional embodiments are conceivable. For example, where a different cure is given to a hatch type and it corresponding fill type as compared to the exposure given to the other hatch and fill types, wherein the net resulting exposure still produces the desired skin depth. It is also possible to extend this approach to include other sources of print through, such as that due to crosshatch from the layer above the one that contains the down-facing feature. The cross hatch on this higher layer can actually print through the lower layer. Using a particular material, this print through effect is reduced when larger layer thicknesses are used and increased when smaller layer thicknesses are used. Using experimental or analytical methods, the amount of print through can be determined, and the cross hatch on the layer containing the down-facing feature can be given a correspondingly lower cure. After the exposure of this layer and the following layer, the down-facing feature will have a uniform cure. In most cases, there are crosshatch vectors on the layer immediately following the down-facing feature where the above compensation method would be useful. However, on rare occasions, an up-facing feature may be on the same layer as a down-facing feature (therefore the feature is only one layer in thickness), requiring the hatch and fill to be perfectly matched based on the one layer thickness of cure. On layers that have both up- and down- facing features in the same area, it is important to insure that only the down-facing skin is cured, so as not to use more exposure than desired.

In the above description, only one effective cure width has been exemplified to describe the proximity with which vectors can approach one another, but more than one ECW and EEP can be used in appropriate circumstances.

The methods described herein have been implemented and verified experimentally using x- and y- hatch and fill without need of modified software. An object can be sliced using x- and y- hatch and x- and y- skin fill. The SLI file created can then be edited by hand, removing the skin fill vectors that are within a specific distance of their parallel hatch vectors (this distance is the ECW). This SLI file can then be merged with a support file. The range file can then be prepared giving an equal cure to the x- and y- hatch, and an appropriate single line exposure given to the fill vectors in order to produce an equivalent total exposure as that from the x and y hatch.

Alternatively, the software can be modified:

1) by creating a skin type corresponding to 60° cross hatch and another corresponding to 120° cross hatch,
2) by creating a slice option (or in some other appropriate program) to allow an offset for skin vectors to not be produced (or not drawn) in the vicinity of hatch paths, and
3) creating an option to allow reduction of cross hatch and fill vectors on each end by a required amount.

Another preferred embodiment of the portion of the present invention dealing with obtaining uniform skin depth is based on the idea of using the same exposure for both the hatch vectors and the skin vectors. The hatch vectors and skin vectors are drawn at the same scanning speed. In the previous embodiment, the net area exposures where the same not the individual vector exposures. In this embodiment there is no need to produce separate crosshatch. Instead, periodically spaced skin vectors are pulled from the skin list and put into a hatch list for exposure prior to exposing the remaining skin vectors. These initially exposed skin vectors function as crosshatch and as such this method no longer requires the computation of the ECW for crosshatch and skin vectors. For the hatch vectors to have adequate strength in order to form a frame for supporting the skin vectors, it may be useful to space the skin vectors at a maximum spacing (but still able to form an adequately uniform cure depth) so that the individual skin/hatch vectors will be relatively strong.

## Preferred Methods of Selecting and Determining Cure Depth

To make a theoretical determination of skin thickness, by one or more methods of calculation, one would ordinarily consider the parameters of velocity [step period (SP) and step size (SS)], laser power, beam profile, building material, working curve cure depth and associated maximum cure width, and vector offset. However, if a skin is formed that is several times wider than the laser beam, and a step size and an offset are used that are several times smaller than the laser beam width, the energy distribution over the skinned area will be substantially uniformly distributed. If the energy is uniformly distributed, the area will be uniformly cured to a particular depth depending on the exposure. Thus, the exposure is defined as, Energy per unit area = Laser Power x Step Period / (Step Size x Offset) . This above relationship can be equated to a particular thickness by plotting thickness versus log of exposure which, if the resin absorption obeys Beer's law will result in a linear relationship. From this relationship, one can determine the slope and intercept of this plot. Since the above relationship does not explicitly contain focus, profile, and machine working curve parameters, the constants determined for one machine should be directly usable on another machine as long as the parameters of material, wavelength, and distance from the scanning mirrors to the surface of the resin are the same (or accounted for).

The foregoing detailed description and following Examples should be understood as being illustrative rather than limiting, as routine variations and modifications are within the scope of the invention as will be appreciated by one of ordinary skill in the art. Accordingly, it is intended that the invention be limited only by the appended claims, and all equivalents thereof.

## EXAMPLES

## EXAMPLE I

An experiment was conducted to determine whether skinning every layer of a part gives any advantage with regard to minimizing distortion as compared to building techniques based on trapping substantially untransformed material within the limits of the part .

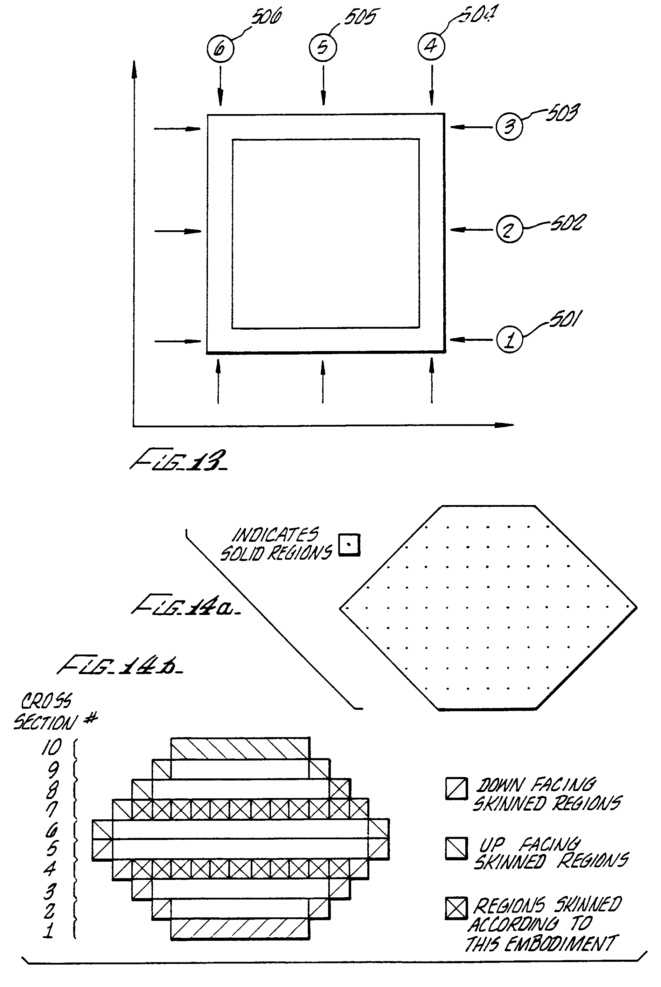

In this experiment, eight parts were built, in groups of two. Each group included an object built on an elevator platform in front of the midpoint of the platform and an object built on the elevator platform behind its midpoint, the objects were identical except for their locations on the building platform. A sample object is depicted in FIGURE 12. Each object was a one inch cube with no top and no bottom but with a wall thickness of 100 mils. Various slicing and merging options were used to create four different groups:

| Grp Name | Description |
| --- | --- |
| Skntin01 | Front object has skin on every layer. |
| | Rear object has skin only on top and bottom layers. |
| Skntin02 | Front object has skin only on top and bottom layers. |
| | Rear object has skin on every layer. |
| Skntin03 | Front object has skin on every layer. |
| | Rear object has skin on every layer. |
| Skntin04 | Front object has skin only on top and bottom layers. |
| | Rear object has skin only on top and bottom layers. |

All (8 parts) 4 groups were built with the following parameters:

Layer thickness - 0,508 mm (20 mils).

Cure thickness for layer boundaries - 0,660 mm (26 mils).

Cure thickness for layer hatch - 0,660 mm (26 mils).

Hatch vectors ran parallel to the x-axis and the y-axis spaced at 1,27 mm (50 mils) and skin vectors ran parallel to the X-axis.

Cure thickness for skin fill was not specified as thickness but as 1/2 the step period (SP) for a 0,660 mm (26 mil) cure (with an SS of 2) and step size (SS) of 16. All skin fill vectors ran parallel to the x-axis with a 0,051 mm (2 mil) offset between them. (As a side note, measurement of skin thickness under similar cure conditions indicated that the cure thickness was approximately 0,508 mm (20 mils). The building material was SLR 800, manufactured by DeSoto Chemical.

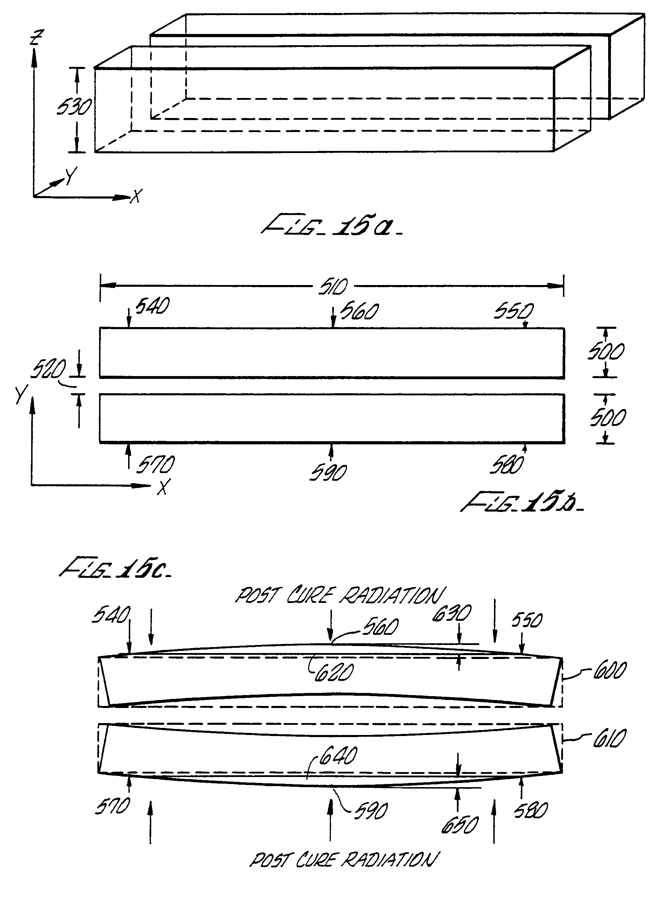

Measurements were made on each part to determine the resulting structural accuracy of the part. No attempt was made to compensate for cure shrinkage. A series of measurements were made near the top of each part. The measurements are depicted in FIGURE 13. They are labeled 501 to 506. Measurements 501 to 503 measure distances parallel to the X axis, while measurements 504 to 506 measure distances parallel to the Y axis. The amount of distortion of the part along the X-axis is defined as

Distortion (X) = ( 501 + 503 ) / 2 - 502,

similarly distortion along the Y-axis is defined as

Distortion (Y) = ( 504 + 506 ) / 2 - 505.

The parts were skinned in the X-direction, the X-distortion is the distortion of the wall perpendicular to the skinning direction and the Y-distortion is the distortion of the wall parallel to the direction of skinning.

The results are summarized as follows:

Skntin01

Front object, all layers skinned along the X-direction

- distortion of wall perpendicular to direction of skinning = 0,091 mm (3.6 mils)
- distortion of wall parallel to direction of skinning = 0,239 mm (9.4 mils)

Rear Object, Standard building, skinned only top & bottom

- distortion of wall perpendicular to direction of skinning = 9.6
- distortion of wall parallel to direction of skinning = 9.7

Skntin02

Rear Object, all layers skinned along the X direction

- distortion of wall perpendicular to direction of skinning = 0,030 mm (1.2 mils)
- distortion of wall parallel to direction of skinning = 0,208 mm (8.2 mils)

Front Object, Standard building, skinned only top & bottom

- distortion of wall perpendicular to direction of skinning = 0,231 mm (9.1 mils)
- distortion of wall parallel to direction of skinning = 0,178 mm (7.0 mils)

Skntin03

Rear Object, all layers skinned along the X direction

- distortion of wall perpendicular to direction of skinning = 0,038 mm (1.5 mils)
- distortion of wall parallel to direction of skinning = 0,201 mm (7.9 mils)

Front Object, all layers skinned along the X direction

- distortion of wall perpendicular to direction of skinning = 0,051 mm (2.0 mils)
- distortion of wall parallel to direction of skinning = 0,196 mm (7.7 mils)

Skntin04

Front Object, Standard building, skinned only top & bottom

- distortion of wall perpendicular to direction of skinning = 0,279 mm (11.0 mils)
- distortion of wall parallel to direction of skinning = 0,246 mm (9.7 mils)

Rear Object, Standard building, skinned only top & bottom

- distortion of wall perpendicular to direction of skinning = 0,241 mm (9.5 mils)
- distortion of wall parallel to direction of skinning = 0,201 (7.9 mils)

In summary, skinning each layer in the x-direction reduced distortion in dimensions measured parallel, but not perpendicular, to the X-axis.

**EXAMPLE II**

In a second experiment, parts were built by skinning each layer with skin that was perpendicular to the direction of the skin on the previous layer. In other words parts were built with X-type skin fill on every other layer and Y-type skin on the other layers. The parts were the same as those described for Example I, except for the differences in skinning.

**Part GB349**

Front Object, Every layer skinned, alternating X and Y types

- Distortion (X) = 0,124 mm (4.9 mils)
- Distortion (Y) = 0,112 mm (4.4 mils)

Rear Object, Standard building, skinned only top & bottom

- Distortion (X) = 0,102 mm (4.0 mils)
- Distortion (Y) = 0,135 mm (5.3 mils)

**Part GB350**

Front Object, Standard building, skinned only top & bottom

- Distortion (X) = 0,079 mm (3.1 mils)
- Distortion (Y) = 0,188 mm (7.4 mils)

Rear Object, Every layer skinned, alternating X and Y types

- Distortion (X) = 0,127 mm (5.0 mils)
- Distortion (Y) = 0,069 mm (-2.7 mils)

**Part GB351**

Front, Standard building, skinned only top & Bottom

- Distortion (X) = 0,135 mm (5.3 mils)
- Distortion (Y) = 0,157 mm (6.2 mils)

Rear, Standard building, skinned only top & Bottom

- Distortion (X) = 0,239 mm (9.4 mils)
- Distortion (Y) = 0,173 mm (6.8 mils)

**Part GB352**

Front Object, Every layer skinned, alternating X and Y types

- Distortion (X) = 0,063 mm (2.5 mils)
- Distortion (Y) = 0,0762 (3.0 mils)

Rear Object, Every layer skinned, alternating X and Y types

- Distortion (X) = 0,048 mm (1.9 mils)
- Distortion (Y) = 0,104 mm (4.1 mils)

**Part GB354**

Front Object, Skinned on every layers all skin of the Y-type

- Distortion (X) = 0,152 mm (6.0 mils)
- Distortion (Y) = 0,025 mm (1.0 mils)

Rear Object, Skinned on every layer, all skin of the X-type

- Distortion (X) = 0,038 mm (1.5 mils)
- Distortion (Y) = 0,191 mm (7.5 mils)

In summary, this data has substantial scatter but one can conclude that skinning in x- and y- directions on opposite layers appears to generally reduce distortion to some extent in each direction.

## EXAMPLE III

Similar experiments to those set forth in Examples I and II tended to show that providing both x- and y- skin fill on each layer generally reduced distortion in both x- and y- directions.

Similar experiments to those set forth in Examples I and II showed that providing, X- skin fill along with X, 60, and 120 degree hatch on each cross-section substantially reduced distortion in both directions.

## EXAMPLE IV

Four 1" x 1" squares were built in a single build process on a stereolithographic apparatus. Each square consisted of six 0,508 mm (20 mil) layers. The structural support for each layer was based on x- and y- cross hatch, spaced at a 1,27 mm (50 mil) separation. Each square was supported by a grid of webs placed at a spacing of 1/4". The webs consisted of ten 0,508 mm (20 mil) layers. On the top surface of each square a standard skinning technique was applied. Therefore, the top surface was given x skin fill spaced at 0,051 mm (2 mils) on top of a grid of x- and y- crosshatch. The supporting web structures were numbered 1 through 4 while the square patches were numbered 5 through 8 (based on the merge order).

On the first layer of each square, x- and y- hatch were applied using a particular exposure along with a particular skinning technique and associated exposure. The second through sixth layers were given the standard 0,660 mm (26 mil) cure depth for boundaries and hatch. On the first layer the boundary vectors were given the full desired cure depth, without factoring in any reduction in hatch and skin vectors for the purpose of minimizing multiple exposures in boundary regions. The skinning/exposure technique was varied for the first layer of each patch.

Square Patch 5: "Standard Approach to Down-Facing Skins"

    boundary = 0,660 mm (26 mil) cure (SP 65, SS 2)
    x- and y- cross hatch = 0,660 mm (26 mil) cure (SP 65, SS 2)
    x- skin fill = half the SP of a 0,660 mm (26 mil) exposure if SS = 2 (SP 33, SS 16); fill vectors spaced at 0,051 mm (2 mils) with no gaps except exact duplicates of hatch.
    y- skin fill = None

Square Patch 6: "Down-Facing Skins with Skin Slightly Under-Exposed"

    x- and y- cross hatch = 0,502 mm (20 mil) cure (SP 29, SS 2)
    boundary = 0,508 mm (20 mil) cure (SP 29, SS 2)
    x- skin fill = SP for a 0,406 mm (16 mil) cure if SS = 2 (SP 17, SS 16); fill vectors spaced at 0,051 mm (2 mils) with vectors removed that are 0,051 mm (2 mils) and 0,102 mm (4 mils) from parallel hatch vectors (this means the skin fill vectors that are closest to the hatch are 0,152 mm (6 mils) away).
    y- skin fill = SP for a 0,406 mm (16 mil) cure if SS = 2 (SP 17, SS 16); fill vectors spaced at 0.051 mm (2 mils) with vectors removed that are 0,051 mm (2 mils) and 0,102 mm (4 mils) from parallel hatch vectors.

Square Patch 7: "Down-Facing Skins with Skin Exposure Closely Matched to Cross Hatch Exposure"

    boundary = 0,508 mm (20 mil) cure (SP 29, SS 2)
    x- and y- cross hatch = 0,508 mm (20 mil) cure (SP 29, SS 2)
    x- skin fill = SP for a 0,508 mm (20 mil) cure if SS = 2 (SP 29, SS 16); fill vectors spaced at 0,051 mm (2 mils) with vectors removed that are 0,051 mm (2 mils) and 0,102 mm (4 mils) from parallel hatch vectors.
    y- skin fill = SP for a 0,508 mm (20 mil) cure if SS = 2 (SP 29, SS 16); fill vectors spaced at 0.051 mm (2 mils) with vectors removed that are 0,051 mm (2 mils) and 0,102 mm (4 mils) from parallel hatch vectors.

Square Patch 8: "Down-Facing Skins with the Skin Slightly Over-Exposed"

    boundary = 0,508 mm (20 mil) cure (SP 29, SS 2)
    x- and y- cross hatch = 0,508 mm (20 mil) cure (SP 29, SS 2)
    x- skin fill = SP for a 0,660 mm (26 mil) cure if SS = 2 (SP 65, SS 16);
    fill vectors spaced at 0,051 mm (2 mils) with vectors removed that are 0,051 and 0,102 mm (2 and 4 mils) from parallel hatch vectors.

y- skin fill = SP for a 0,660 mm (26 mil) cure if SS = 2 (SP 65, SS 16);

fill vectors spaced at 0,051 mm (2 mils) with vectors removed that are 0,051 and 0,102 mm (2 and 4 mils) from parallel hatch vectors.

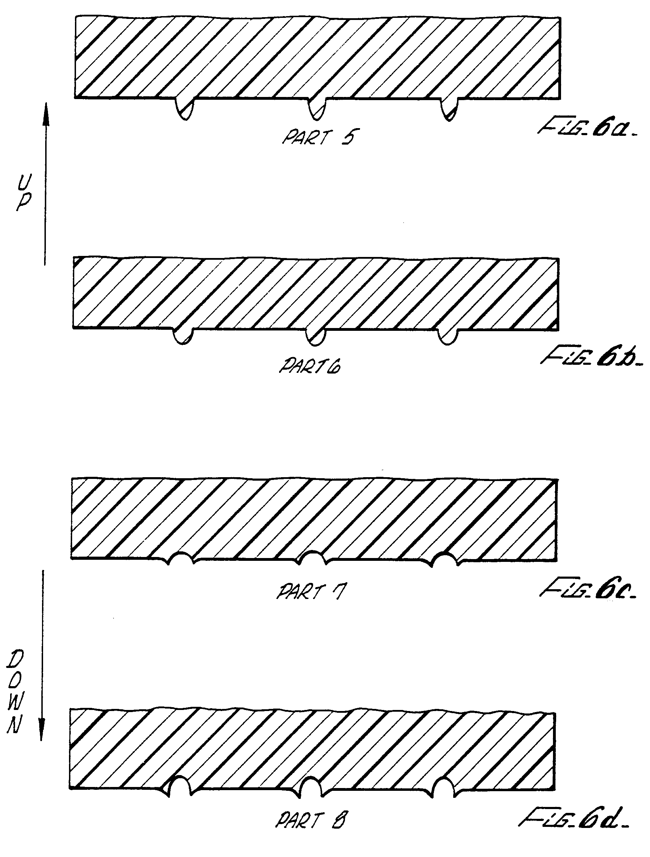

After building these four square patches they were examined, and none of the parts showed any signs of distortion. Part 5 had the typical large waffle with cross hatch protruding beyond the skin. Part 6 had a smaller waffle with cross hatch protruding beyond the skin. Part 7 had cross hatch and skin fill cured down to approximately the same level. However, there were slight protrusions along the sides of the cross hatch and a slight depression in the center of the cross hatch indicating that the skin was slightly overcured and maybe that the skin was not cured within the proper effective cure width of the cross hatch. Part 8 seemed to have cross hatch whose center line was depressed as compared to the skin and to a raised overlapping edge where skin and cross hatch joined. The size of the discontinuities in Part 8 were larger than those in Part 7. See FIGURES 6a-6d for a sketch of each of these cases.

A scratch test indicated that Part 7 was almost smooth, Part 8 was slightly rougher, Part 6 was much rougher, and finally Part 5 was the roughest of all. A visual inspection indicated that Part 7 looked best, followed by Part 8 or 6, then finally by Part 5.

The results of this experiment showed that the technique disclosed herein reduced waffle considerably. With the parameters used in this test, hatch strength appeared to be sufficient to support the skin without distortion.

## EXAMPLE V

Experiments were done to test the usefulness of "Weave" for building parts without increasing the vertical distortion of the parts or the need for adding additional supports.

In a first experiment 8 parts were built with the purpose of determining the most appropriate cure depths to use with the first pass of crosshatch in a weave building technique. The parts were built with 0,254 mm (10 mil) layers, using XB-5081 stereolithography resin with a HeCd laser of 14.8 mW, and a beam diameter of 0,221 to 0,229 mm (8.7 to 9.0 mils). The parts were built with boundaries and with X and Y hatch according to the "Weave" embodiment described earlier. That is, the spacing between crosshatch vectors was somewhat greater than the cure width associated with curing the vectors. The boundary vectors were given a 0,406 mm (16 mil) cure and the cure depth for the first pass of the crosshatch was varied from part to part. Adhesion between layers was obtained by the overcure of the boundaries and the net cure depth (overcure) of the intersection points of 2 equally exposed intersecting pairs of crosshatch vectors. The cure depths for the first pass of the crosshatch for different parts were 7, 8, 9, 10, 11, 12, 13, and 14 x 0,0254 mm ($\cong$ 1 mil). It was found that the parts that used initial crosshatch exposures to obtain initial cure depths of 7, 8, and 9 x 0,0254 mm ($\cong$ 1 mil) showed no sign of curl but they did demonstrate adequate adhesion. The parts built with 0,254 mm (10 mils) and greater initial crosshatch cure depth demonstrated unacceptable curl. Therefore, it is concluded that the first exposure of crosshatch in the preferred weave embodiment should be based on a cured depth less than the layer thickness. It is possible that a cure depth somewhat greater than the layer thickness would be acceptable for certain materials that wouldn't show significant bonding between layers for small overcures.

A second experiment similar to the above was done to look at the most appropriate hatch spacing to use with the "Weave" building method. The material used was XB 5081, the layer thickness was 0,254 mm (10 mils), the cure depth for boundaries was 0,305 mm (12 mils), the cure depth for the first pass of crosshatch was 0,203 mm (8 mils), and the beam diameter was 0,224 mm 8.8 mils (maximum cure width = 0,254 mm (10 mils)). The hatch spacing for the different parts were 3, 5, 7, 9, 11, 13, 15, and 17 x 0,0254 mm ($\cong$ 1 mil). It was found that the parts built with spacings of 0,381 and 0,432 mm (15 and 17 mils) didn't have adequate structural integrity. The parts built with spacings of 3, 5, 7, and 9 x 0,0254 mm ($\cong$ 1 mil) showed unacceptable curl. Finally, the parts built with a spacing of 0,279 and 0,330 mm (11 and 13 mils) (as well as the parts built with spacings of 0,381 and 0,432 mm (15 and 17 mils)) showed no signs of excessive curl.

## EXAMPLE VI

An experiment was done to compare the post cure distortion of parts build using the preferred "Weave" building method, the standard building method, and the standard spacing but staggered hatch building method.

This experiment consisted of building a series of parts with different building parameters. The parts were then cleaned and measured on a coordinate measuring machine (CMM). This first set of measurements measured the green (only partially cured) part. The parts were then identically postcured followed by another set of measurements of the parts on the CMM. This second set of measurements measured the fully cured part.

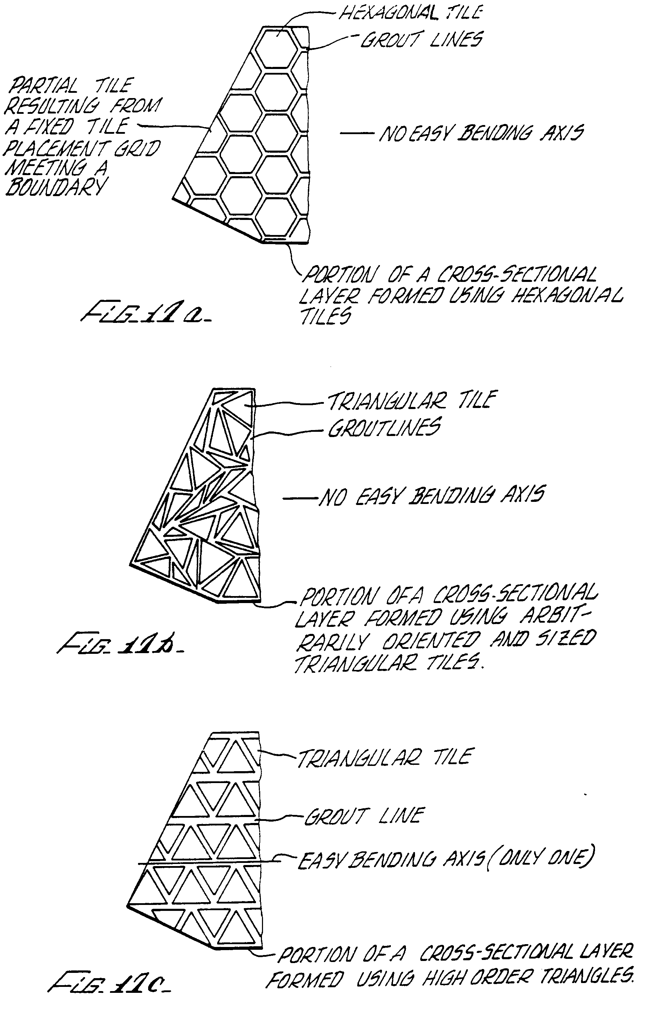

The parts used in this experiment are depicted in FIGURE 15. FIGURE 15a depicts two vertical walls built side by side with a small separation between them. The height of each wall 530 was 25,4 mm (1.000 inch). The parts were built and measured while attached to Web Supports that were attached to the building platform (not shown). FIGURE 15b depicts a top view of the two walls. The length of the walls 510 was 101,6 mm (4.000 inches). The width of each wall 500 was 2,54 mm (0.100 inches) and the separation of the walls 520 was 1,27 mm (0.050 inches). Building two substantially back to back walls allowed each wall to be post cured by synergistic stimulation coming from substantially one side of the wall. This one sided curing results in a predictable nonuniform cure of the object and therefore results in a predictable direction of distortion. The measurements made by the CMM on each wall are also depicted in FIGURE 15b. Measurements 540, 550, 570, and 580 were made at approximately 1,27 mm (50 mils or 0.050 inches) from the edge of the wall and approximately 2,54 mm (100 mils) below the upper surface of the wall. Measurements 560 and 590 were made along the same edge of the wall and approximately 2,54 mm (100 mils) below the upper surface of the wall. Measurements 560 and 590 were made along the same edge of the wall and at the same vertical position as measurements 540 and 550 and measurements 570 and 580 respectively. They were made at the horizontal center of the edge of the wall.

FIGURE 15c depicts distortion of the walls induced by post curing. FIGURE 15c depicts a top view of the walls. The dashed lines 600 and 610 represent the desired shape of the walls. Whereas the solid lines represent the actual shape of the walls. To determine the distortion of the first wall, the measurements of points 540 and 550 are connected by a straight line. The amount of distortion 630 is the length along the perpendicular distance between the line and point 560. To determine the distortion of the second wall, the measurements of points 570 and 580 are connected by a straight line. The amount of distortion 650 is the length along the perpendicular distance between the line and point 590.

The parts were built with 0,254 mm (10 mil) layers on a standard SLA-250, manufactured by 3D Systems, using a HeCd laser and building material "XB-5081", manufactured by Ciba-Geigy. The post curing was done in a PCA using 10 - 40 watt black light lamps (disclosed in U.S. Patent Application 07/415,134. The cleaning of the parts was done ultrasonically in an alcohol bath for 2 minutes. Eight pairs of parts were built using the standard bounding technique (that is skinning only the up-facing and down-facing features of the object along with using widely spaced crosshatch to form the internal structure of the part). Four pairs of parts were built using the standard building technique with the modification of staggering the hatch from layer to layer. Two sets of parts were built using the weave approach.

It was found, from the green part measurements, that all the parts had practically no distortion after being removed from the vat and cleaned. The distortion of each part, at this stage, was less than 0,0254 (1 mil). Therefore to study post cure distortion we need only look at the post cure distortion data.

The results of the experiment are summarized below.

| Building Method | Average Distortion |
| --- | --- |
| Regular Hatch | 0,318 mm (12.52 mils) |
| Staggered Hatch | 0,206 mm (8.11 mils) |
| Weave | 0,045 mm 1.76 mils |

From this table we see that both the Staggered hatch and Weave building techniques lead to a substantial decrease in post cure distortion. Weave is seen to be especially useful minimizing this distortion.

## Claims

### Claims for the following Contracting States : DE, FR, GB, NL

1. A stereolithographic method for constructing a three-dimensional object layer-by-layer from a material solidifiable upon exposure to synergistic stimulation, comprising the steps of:
   solidifying a first skin on at least a first portion of a first layer, including more than the exterior surfaces of the object, by selectively exposing said material to synergistic stimulation providing a first set of parallel skin vectors;
   solidifying a second skin on at least a second portion of a second layer or said first skin of said first layer by selectively exposing said material to synergistic stimulation providing a second set of parallel skin vectors, wherein said vectors of said first set are not parallel to said vectors of said second set.

2. The method of claim 1 additionally comprising the step of:
   solidifying a boundary of said first layer by exposing the material in a vector pattern which traces the boundary of said first layer.

3. The method of claims 1 or 2 wherein said second layer is the next immediately consecutively formed layer after formation of said first layer.

4. The method of claim 3 wherein each layer is at least partially skinned and the skinning direction alternates between each immediately consecutively formed layer.

5. The method of any of claims 1-4, additionally comprising the step of:
solidifying a portion of a layer by selectively exposing said material to synergistic stimulation comprising at least a first set of hatch lines.

6. The method of any of claims 1-5 wherein the portions to be exposed define a tiling pattern.

7. The method of any of claims 1-5 wherein all layers of said object are skinned.

8. The method of any of claims 1-6 wherein more than down-facing and up-facing regions are skinned but less than all portions of all layers are skinned.

9. The method of any of claims 1-5 wherein said first set and said second set of vectors comprise external skin vectors.

10. The method of any of claims 1-9 further comprising the step of: utilizing a technique selected from the group consisting of smalleys, rivets, webs, multipass and any combination thereof to reduce distortion of said skins.

11. The method of any of claims 1-10 wherein said first set of skin vectors comprises first and second subsets of skin vectors wherein the skin vectors of the first subset are non-adjacent skin vectors and the skin vectors of the second subset are interposed between the skin vectors of the first subset.

12. The method of any of claims 1-11 wherein said first set of skin vectors is perpendicular to the second set of skin vectors.

13. The method of any of claims 1-12 wherein the material comprises a liquid.

14. The method of any of claims 1-13 wherein the material comprises a photopolymer.

15. The method of any of claims 1-12 wherein the material comprises a powder.

16. The method of any of claims 1-15 wherein the synergistic stimulation is a UV laser beam.

17. The method of any of claims 1-16 wherein consecutive skin vector spacing is from about 0.025 to about 0.1 mm (about 1 to about 4 mils) for a maximum cure width of a single exposure being about 0.356 to 0.381 mm (14 to 15 mils).

18. A stereolithographic apparatus for constructing a three-dimensional object layer-by-layer from a fluid-like material solidifiable upon exposure to synergistic stimulation, comprising:
means for solidifying a first skin on at least a first portion of a first layer, including more than the exterior surfaces of the object, by selectively exposing said material to synergistic stimulation providing a first set of parallel skin vectors;
means for solidifying a second skin on at least a second portion of a second layer or said first skin of said first layer by selectively exposing the material to synergistic stimulation providing a second set of parallel skin vectors; wherein said vectors of said first set are not parallel to said vectors of said second set.

19. The apparatus of claim 18, additionally comprising:
means for solidifying a boundary of said first layer by exposing the material in a vector pattern which traces the boundary of the first layer.

20. The apparatus of claims 18 or 19 wherein said second layer is the next immediately consecutively formed layer after formation of said first layer.

21. The apparatus of claim 20 wherein each layer is at least partially skinned and the skinning direction alternates between each immediately consecutively formed layer.

22. The apparatus of any of claims 18-21, additionally comprising:
means for solidifying a portion of a layer by selectively exposing material to synergistic stimulation comprising at least a first set of hatch lines.

23. The apparatus of any of claims 18-22 comprising means for defining said portions to be exposed as a tiling pattern.

28

**24.** The apparatus of any of claims 18-22, comprising means for skinning all layers of said object.

**25.** The apparatus of any of claims 18-23, comprising means for skinning more than down-facing and up-facing regions, but less than all portions of all layers.

**26.** The apparatus of any of claims 18-22 wherein said first set and said second set of vectors comprise external skin vectors.

**27.** The apparatus of any of claims 18-26 further comprising:
means for utilizing a technique selected from the group consisting of smalleys, rivets, webs, multipass and any combination thereof to reduce distortion of said skins.

**28.** The apparatus of any of claims 18-27, comprising means for defining said first set of skin vectors to comprise first and second subsets of skin vectors wherein the skin vectors of the first subset are non-adjacent skin vectors and the skin vectors of the second subset are interposed between the skin vectors of the first subset.

**29.** The apparatus of any of claims 18-28 wherein the first set of skin vectors is perpendicular to the second set of skin vectors.

**30.** The apparatus of any of claims 18-29 wherein the material comprises a liquid.

**31.** The apparatus of any of claims 18-30 wherein the material comprises a photopolymer.

**32.** The apparatus of any of claims 18-29 wherein the material comprises a powder.

**33.** The apparatus of any of claims 18-32 wherein the synergistic stimulation is a laser beam.

**34.** The apparatus of any of claims 18-33 wherein consecutive skin vector spacing is from about 0.025 to about 0.1 mm (about 1 to about 4 mils) for a maximum cure width of a single exposure being about 0.356 to 0.381 mm (14 to 15 mils).

**Claims for the following Contracting States : IT, SE, LI, CH, BE, AT, LU, ES, GR, DK**

**1.** A stereolithographic method for constructing a three-dimensional object layer-by-layer from a fluid-like material solidifiable upon exposure to synergistic stimulation, comprising the steps of:
solidifying a first skin on at least a first portion of a first layer, including more than the exterior surfaces of the object, by selectively exposing said material to synergistic stimulation providing a first set of parallel skin lines;
solidifying a second skin on at least a second portion of a second layer or said first skin of said first layer by selectively exposing said material to synergistic stimulation providing a second set of parallel skin lines, wherein said lines of said first set are not parallel to said lines of said second set.

**2.** The method of claim 1 wherein said first and second set of skin lines is provided by vector data.

**3.** The method of claim 2, additionally comprising the step of:
soldidifying a boundary of said first layer by exposing the material in a vector pattern which traces the boundary of said first layer.

**4.** The method of any of claims 1-3 wherein the second layer is the next immediately consecutively formed layer after formation of the first layer.

**5.** The method of claim 4 wherein each layer is at least partially skinned and the skinning direction alternates between each immediately consecutively formed layer.

**6.** The method of any of claims 1-5, additionally comprising the step of:
solidifying a portion of a layer by selectively exposing material to synergistic stimulation comprising at least a first set of hatch lines.

**7.** The method of any of claims 1-6 wherein the portions to be exposed define a tiling pattern.

**8.** The method of any of claims 1-6 wherein all layers of said object are skinned.

9. The method of any of claims 1-7 wherein more than down-facing and up-facing regions are skinned but less than all portions of all layers are skinned.

10. The method of any of claims 2-6 wherein said first set and said second set of vectors comprise external skin vectors.

11. The method of any of claims 2-10 further comprising the step of:
utilizing a technique selected from the group consisting of smalleys, rivets, webs, multipass and any combination thereof to reduce distortion of said skins.

12. The method of any of claims 2-11 wherein the first set of skin vectors comprises first and second subsets of skin vectors wherein the skin vectors of the first subset are non-adjacent skin vectors and the skin vectors of the second subset are interposed between the skin vectors of the first subset.

13. The method of any of claims 2-12 wherein the first set of skin vectors is perpendicular to the second set of skin vectors.

14. The method of any of claims 1-13 wherein the material comprises a liquid.

15. The method of any of claims 1-14 wherein the material comprises a photopolymer.

16. The method of any of claims 1-13 wherein the material comprises a powder.

17. The method of any of claims 1-16 wherein the synergistic stimulation is a UV laser beam.

18. The method of any of claims 2-17, wherein consecutive skin vector spacing is from about 0.025 to about 0.1 mm (about 1 to about 4 mils) for a maximum cure width of a single exposure being about 0.356 to 0.381 mm (14 to 15 mils).

19. A stereolithographic apparatus for constructing a three-dimensional object layer-by-layer from a fluid-like material solidifiable upon exposure to synergistic stimulation, comprising:
means for solidifying a first skin on at least a first portion of a first layer, including more than the exterior surfaces of the object, by selectively exposing said material to synergistic stimulation providing a first set of parallel skin lines;
means for solidifying a second skin on at least a second portion of a second layer or said non-boundary portion of said first layer by selectively exposing said material to synergistic stimulation providing a second set of parallel skin lines; wherein
said lines of said first set are not parallel to said lines of said second set.

20. The apparatus of claim 19, wherein said solidification means comprises means for providing said skin lines of said first and second sets by vector data.

21. The appartus of any of claims 19 or 20, additionally comprising:
means for solidifying a boundary of said first layer by exposing said material in a vector pattern which traces the boundary of said first layer.

22. The apparatus of any of claims 19-21 wherein the second layer is the next immediately consecutively formed layer after formation of the first layer.

23. The apparatus of claim 22 wherein each layer is at least partially skinned and the skinning direction alternates between each immediately consecutively formed layer.

24. The apparatus of any of claims 19-23, additionally comprising:
means for solidifying a portion of a layer by selectively exposing material to synergistic stimulation comprising at least a first set of hatch lines.

25. The apparatus of any of claims 19-24, comprising means for defining said portions to be exposed as a tiling pattern.

26. The apparatus of any of claims 19-24, comprising means for skinning all layers of said object.

27. The apparatus of any of claims 19-25, comprising means for skinning more than down-facing and up-facing regions, but less than all portions of all layers.

28. The apparatus of any of claims 20-24, as far as they refer back to claim 20, wherein said first set and said second set of vectors comprise external skin vectors.

29. The apparatus of any of claims 20-28 further comprising:
means for utilizing a technique selected from the group consisting of smalleys, rivets, webs, multipass and any combination thereof to reduce distortion of said skins.

30. The apparatus of any of claims 20-29, as far as they refer back to claim 20, comprising means for defining said first set of skin vectors to comprise first and second subsets of skin vectors wherein the skin vectors of the first subset are non-adjacent skin vectors and the skin vectors of the second subset are interposed between the skin vectors of the first subset.

31. The apparatus of any of claims 20-30, as far as they refer back to claim 20, wherein the first set of skin vectors is perpendicular to the second set of skin vectors.

32. The apparatus of any of claims 19-31 wherein the material comprises a liquid.

33. The apparatus of any of claims 19-32 wherein the material comprises a photopolymer.

34. The apparatus of any of claims 19-31 wherein the material comprises a powder.

35. The apparatus of any of claims 19-34 wherein the synergistic stimulation is a laser beam.

36. The apparatus of any of claims 20-35, as far as they refer back to claim 20, wherein consecutive skin vector spacing is from about 0.025 to about 0.1 mm (about 1 to about 4 mils) for a maximum cure width of a single exposure being about 0.356 to 0.381 mm (14 to 15 mils).

**Patentansprüche**

**Patentansprüche für folgende Vertragsstaaten : DE, FR, GB, NL**

1. Ein stereolithographisches Verfahren zur schichtweisen Herstellung eines dreidimensionalen Objekts aus einem Material, das sich durch Aussetzung einer synergistischen Stimulierung verfestigt, das die folgenden Schritte umfaßt:
eine erste Hülle wird auf zumindest einem ersten Abschnitt einer ersten Schicht verfestigt, der mehr als die äußeren Oberflächen des Objekts enthält, indem das Material selektiv synergistischer Stimulierung ausgesetzt wird, die für eine erste Menge paralleler Hüllvektoren sorgt;
eine zweite Hülle wird auf zumindest einem zweiten Abschnitt einer zweiten Schicht oder der ersten Hülle der ersten Schicht verfestigt, indem das Material selektiv synergistischer Stimulierung ausgesetzt wird, die für eine zweite Menge paralleler Hüllvektoren sorgt, wobei
die Hüllvektoren der ersten Menge nicht parallel zu den Hüllvektoren der zweiten Menge sind.

2. Verfahren nach Anspruch 1, das ferner den Schritt aufweist:
ein Rand der ersten Schicht wird verfestigt, indem das Material synergistischer Stimulierung in einem Vektormuster ausgesetzt wird, das den Rand der ersten Schicht abfährt.

3. Verfahren nach einem der Ansprüche 1 oder 2, wobei die zweite Schicht die nächste unmittelbar nach Bildung der ersten Schicht gebildete Schicht ist.

4. Verfahren nach Anspruch 3, wobei jede Schicht zumindest teilweise mit einer Hülle versehen wird, und die Richtung, in der jede Schicht mit einer Hülle versehen wird, sich zwischen jeder unmittelbar darauffolgend gebildeten Schicht ändert.

5. Verfahren nach einem der Ansprüche 1 - 4, das ferner den Schritt aufweist:
ein Abschnitt einer Schicht wird verfestigt, indem das Material selektiv synergistischer Stimulierung ausgesetzt wird, die zumindest eine erste Menge Schraffurlinien umfaßt.

6. Verfahren nach einem der Ansprüche 1 - 5, wobei die Abschnitte, die synergistischer Stimulierung ausgesetzt werden sollen, ein Kachelmuster (tiling pattern) definieren.

7. Verfahren nach einem der Ansprüche 1 - 5, wobei alle Schichten des Objektes mit Hüllen versehen werden.

8. Verfahren nach einem der Ansprüche 1 - 6, wobei mehr als nach unten freie und nach oben freie Bereiche mit Hüllen versehen werden, aber weniger als alle Abschnitte aller Schichten mit Hüllen versehen werden.

9. Verfahren nach einem der Ansprüche 1 - 5, wobei die erste Menge und die zweite Menge der Vektoren externe Hüllvektoren umfassen.

10. Verfahren nach einem der Ansprüche 1 - 9, das ferner den Schritt aufweist:
Herabsetzen der Verwindung der Hüllen durch eine Technik, die aus der Gruppe bestehend aus Ösen (Smalleys), Nieten, Waben, Mehrfachdurchlauf und einer beliebigen Kombination davon ausgewählt ist.

11. Verfahren nach einem der Ansprüche 1 - 10, wobei die erste Menge Hüllvektoren eine erste und zweite Untermenge von Hüllvektoren umfaßt, wobei die Hüllvektoren der ersten Untermenge nicht benachbarte Hüllvektoren sind, und die Hüllvektoren der zweiten Untermenge zwischen den Hüllvektoren der ersten Untermenge liegen.

12. Verfahren nach einem der Ansprüche 1 - 11, wobei die Hüllvektoren der ersten Menge und die der zweiten Menge senkrecht aufeinander stehen.

13. Verfahren nach einem der Ansprüche 1 - 12, wobei das Material eine Flüssigkeit umfaßt.

14. Verfahren nach einem der Ansprüche 1 - 13, wobei das Material einen Photopolymer umfaßt.

15. Verfahren nach einem der Ansprüche 1 - 12, wobei das Material ein Pulver umfaßt.

16. Verfahren nach einem der Ansprüche 1 - 15, wobei die synergistische Stimulierung ein UV-Laserstrahl ist.

17. Verfahren nach einem der Ansprüche 1 - 16, wobei der Abstand zwischen aufeinanderfolgenden Hüllvektoren im Bereich zwischen ungefähr 0,025 - 0,1 mm (ungefähr 1 - 4 mils) liegt, für eine maximale Aushärtbreite einer einzelnen Exposition, die ungefähr 0,356 bis 0,381 mm (14 - 15 mils) ist.

18. Eine stereolithographische Vorrichtung zur schichtweisen Herstellung eines dreidimensionalen Objekts aus einem flüssigkeitsähnlichen Material, das sich durch Aussetzung einer synergistischen Stimulierung verfestigt, mit:
Mitteln, um eine erste Hülle auf zumindest einem ersten Abschnitt einer ersten Schicht zu verfestigen, der mehr als die äußeren Oberflächen des Objekts enthält, indem das Material selektiv synergistischer Stimulierung ausgesetzt wird, die für eine erste Menge paralleler Hüllvektoren sorgt;
Mitteln, um eine zweite Hülle auf zumindest einem zweiten Abschnitt einer zweiten Schicht, oder der ersten Hülle der ersten Schicht zu verfestigen, indem das Material selektiv synergistischer Stimulierung ausgesetzt wird, die für eine zweite Menge paralleler Hüllvektoren sorgt; wobei
die Hüllvektoren der ersten Menge nicht parallel zu den Hüllvektoren der zweiten Menge sind.

19. Vorrichtung nach Anspruch 18, die ferner aufweist:
Mittel, um einen Rand der ersten Schicht zu verfestigen, indem das Material synergistischer Stimulierung in einem Vektormuster ausgesetzt wird, das den Rand der ersten Schicht abfährt.

20. Vorrichtung nach einem der Ansprüche 18 oder 19, wobei die zweite Schicht die nächste unmittelbar nach Bildung der ersten Schicht gebildete Schicht ist.

21. Vorrichtung nach Anspruch 20, wobei jede Schicht zumindest teilweise mit einer Hülle versehen wird, und die Richtung, in der jede Schicht mit einer Hülle versehen wird, sich zwischen jeder unmittelbar darauffolgend gebildeten Schicht ändert.

22. Vorrichtung nach einem der Ansprüche 18 - 21, die ferner aufweist:
Mittel, um einen Abschnitt einer Schicht zu verfestigen, indem das Material selektiv synergistischer Stimulierung ausgesetzt wird, die zumindest eine erste Menge Schraffurlinien umfaßt.

23. Vorrichtung nach einem der Ansprüche 18 - 22, wobei die Abschnitte, die synergistischer Stimulierung ausgesetzt werden sollen, ein Kachelmuster (tiling pattern) definieren.

**24.** Vorrichtung nach einem der Ansprüche 18 - 22, die Mittel umfaßt, um alle Schichten des Objektes mit Hüllen zu versehen.

**25.** Vorrichtung nach einem der Ansprüche 18 - 23, die Mittel umfaßt, um mehr als die nach unten freien und nach oben freien Bereiche mit Hüllen zu versehen, aber weniger als alle Abschnitte aller Schichten mit Hüllen zu versehen.

**26.** Vorrichtung nach einem der Ansprüche 18 - 22, wobei die erste Menge und die zweite Menge der Vektoren externe Hüllvektoren umfassen.

**27.** Vorrichtung nach einem der Ansprüche 18 - 26, die ferner aufweist:
Mittel, um die Verwindung der Hüllen durch eine Technik herabzusetzen, die aus der Gruppe bestehend aus Ösen (Smalleys), Nieten, Waben, Mehrfachdurchlauf und einer beliebigen Kombination davon ausgewählt ist.

**28.** Vorrichtung nach einem der Ansprüche 18 - 27, die Mittel umfaßt, um die erste Menge von Hüllvektoren so zu definieren, daß sie eine erste und zweite Untermenge von Hüllvektoren umfaßt, wobei die Hüllvektoren der ersten Untermenge nicht benachbarte Hüllvektoren sind, und die Hüllvektoren der zweiten Untermenge zwischen den Hüllvektoren der ersten Untermenge liegen.

**29.** Vorrichtung nach einem der Ansprüche 18 - 28, wobei die Hüllvektoren der ersten Menge und die der zweiten Menge senkrecht aufeinander stehen.

**30.** Vorrichtung nach einem der Ansprüche 18 - 29, wobei das Material eine Flüssigkeit umfaßt.

**31.** Vorrichtung nach einem der Ansprüche 18 - 30, wobei das Material einen Photopolymer umfaßt.

**32.** Vorrichtung nach einem der Ansprüche 18 - 29, wobei das Material ein Pulver umfaßt.

**33.** Vorrichtung nach einem der Ansprüche 18 - 32, wobei die synergistische Stimulierung ein UV-Laserstrahl ist.

**34.** Vorrichtung nach einem der Ansprüche 18 - 33, wobei der Abstand zwischen aufeinanderfolgenden Hüllvektoren im Bereich zwischen ungefähr 0,025 - 0,1 mm (ungefähr 1 - 4 mils) liegt, für eine maximale Aushärtbreite einer einzelnen Exposition, die ungefähr 0,356 bis 0,381 mm (14 - 15 mils) ist.

**Patentansprüche für folgende Vertragsstaaten : IT, SE, LI, CH, BE, AT, LU, ES, GR, DK**

**1.** Ein stereolithographisches Verfahren zur schichtweisen Herstellung eines dreidimensionalen Objekts aus einem flüssigkeitsähnlichem Material, das sich durch Aussetzung einer synergistischen Stimulierung verfestigt, das die folgenden Schritte umfaßt:
eine erste Hülle wird auf zumindest einem ersten Abschnitt einer ersten Schicht verfestigt, der mehr als die äußeren Oberflächen des Objekts enthält, indem das Material selektiv synergistischer Stimulierung ausgesetzt wird, die für eine erste Menge paralleler Hüllinien sorgt;
eine zweite Hülle wird auf zumindest einem zweiten Abschnitt einer zweiten Schicht, oder der ersten Hülle der ersten Schicht verfestigt, indem das Material selektiv synergistischer Stimulierung ausgesetzt wird, die für eine zweite Menge paralleler Hüllinien sorgt, wobei
die Linien der ersten Menge nicht parallel zu den Linien der zweiten Menge sind.

**2.** Verfahren nach Anspruch 1, wobei der erste und der zweite Satz von Hüllinien durch Vektordaten bereitgestellt wird.

**3.** Verfahren nach Anspruch 2, das ferner den Schritt aufweist:
ein Rand der ersten Schicht wird verfestigt, indem das Material synergistischer Stimulierung in einem Vektormuster ausgesetzt wird, das den Rand der ersten Schicht abfährt.

**4.** Verfahren nach einem der Ansprüche 1 - 3, wobei die zweite Schicht die nächste unmittelbar nach Bildung der ersten Schicht gebildete Schicht ist.

**5.** Verfahren nach Anspruch 4, wobei jede Schicht zumindest teilweise mit einer Hülle versehen wird, und die Richtung, in der jede Schicht mit einer Hülle versehen wird, sich zwischen jeder unmittelbar darauffolgend gebildeten Schicht ändert.

6. Verfahren nach einem der Ansprüche 1 - 5, das ferner den Schritt aufweist:
ein Abschnitt einer Schicht wird verfestigt, indem das Material selektiv synergistischer Stimulierung ausgesetzt wird, die zumindest eine erste Menge Schraffurlinien umfaßt.

7. Verfahren nach einem der Ansprüche 1 - 6, wobei die Abschnitte, die synergistischer Stimulierung ausgesetzt werden sollen, ein Kachelmuster (tiling pattern) definieren.

8. Verfahren nach einem der Ansprüche 1 - 6, wobei alle Schichten des Objektes mit Hüllen versehen werden.

9. Verfahren nach einem der Ansprüche 1 - 7, wobei mehr als nach unten freie und nach oben freie Bereiche mit Hüllen versehen werden, aber weniger als alle Abschnitte aller Schichten mit Hüllen versehen werden.

10. Verfahren nach einem der Ansprüche 2 - 6, wobei die erste Menge und die zweite Menge der Vektoren externe Hüllvektoren umfassen.

11. Verfahren nach einem der Ansprüche 2 - 10, das ferner den Schritt aufweist:
Herabsetzen der Verwindung der Hüllen durch eine Technik, die aus der Gruppe bestehend aus Ösen (Smalleys), Nieten, Waben, Mehrfachdurchlauf und einer beliebigen Kombination davon ausgewählt ist.

12. Verfahren nach einem der Ansprüche 2 - 11, wobei die erste Menge Hüllvektoren eine erste und zweite Untermenge von Hüllvektoren umfaßt, wobei die Hüllvektoren der ersten Untermenge nicht benachbarte Hüllvektoren sind, und die Hüllvektoren der zweiten Untermenge zwischen den Hüllvektoren der ersten Untermenge liegen.

13. Verfahren nach einem der Ansprüche 2 - 12, wobei die Hüllvektoren der ersten Menge und die der zweiten Menge senkrecht aufeinander stehen.

14. Verfahren nach einem der Ansprüche 1 - 13, wobei das Material eine Flüssigkeit umfaßt.

15. Verfahren nach einem der Ansprüche 1 - 14, wobei das Material einen Photopolymer umfaßt.

16. Verfahren nach einem der Ansprüche 1 - 13, wobei das Material ein Pulver umfaßt.

17. Verfahren nach einem der Ansprüche 1 - 16, wobei die synergistische Stimulierung ein UV-Laserstrahl ist.

18. Verfahren nach einem der Ansprüche 2 - 17, wobei der Abstand zwischen aufeinanderfolgenden Hüllvektoren im Bereich zwischen ungefähr 0,025 - 0,1 mm (ungefähr 1 - 4 mils) liegt, für eine maximale Aushärtbreite einer einzelnen Exposition, die ungefähr 0,356 bis 0,381 mm (14 - 15 mils) ist.

19. Eine stereolithographische Vorrichtung zur schichtweisen Herstellung eines dreidimensionalen Objekts aus einem flüssigkeitsähnlichem Material, das sich durch Aussetzen einer synergistischen Stimulierung verfestigt, mit:
Mitteln, um eine erste Hülle auf zumindest einem ersten Abschnitt einer ersten Schicht zu verfestigen, der mehr als die äußeren Oberflächen des Objekts enthält, indem das Material selektiv synergistischer Stimulierung ausgesetzt wird, die für eine erste Menge paralleler Hüllinien sorgt;
Mitteln, um eine zweite Hülle auf zumindest einem zweiten Abschnitt einer zweiten Schicht, oder der ersten Hülle der ersten Schicht zu verfestigen, indem das Material selektiv synergistischer Stimulierung ausgesetzt wird, die für eine zweite Menge paralleler Hüllinien sorgt; wobei
die Hüllinien der ersten Menge nicht parallel zu den Hüllinien der zweiten Menge sind.

20. Vorrichtung nach Anspruch 19, wobei das Verfestigungsmittel Mittel umfaßt, um den ersten und den zweiten Satz von Hüllinien durch Vektordaten bereitzustellen.

21. Vorrichtung nach Anspruch 19 oder 20, die ferner aufweist:
Mittel, um einen Rand der ersten Schicht zu verfestigen, indem das Material synergistischer Stimulierung in einem Vektormuster ausgesetzt wird, das den Rand der ersten Schicht abfährt.

22. Vorrichtung nach einem der Ansprüche 19 - 21, wobei die zweite Schicht die nächste unmittelbar nach Bildung der ersten Schicht gebildete Schicht ist.

23. Vorrichtung nach Anspruch 22, wobei jede Schicht zumindest teilweise mit einer Hülle versehen wird, und die Richtung, in der jede Schicht mit einer Hülle versehen wird, sich zwischen jeder unmittelbar darauffolgend gebildeten Schicht ändert.

24. Vorrichtung nach einem der Ansprüche 19 - 23, die ferner aufweist:
Mittel, um einen Abschnitt einer Schicht zu verfestigen, indem das Material selektiv synergistischer Stimulierung ausgesetzt wird, die zumindest eine erste Menge Schraffurlinien umfaßt.

25. Vorrichtung nach einem der Ansprüche 19 - 24, wobei die Abschnitte, die synergistischer Stimulierung ausgesetzt werden sollen, ein Kachelmuster (tiling pattern) definieren.

26. Vorrichtung nach einem der Ansprüche 19 - 24, die Mittel umfaßt, um alle Schichten des Objektes mit Hüllen zu versehen.

27. Vorrichtung nach einem der Ansprüche 19 - 25, die Mittel umfaßt, die mehr als die nach unten freien und nach oben freien Bereiche mit Hüllen zu versehen, aber weniger als alle Abschnitte aller Schichten mit Hüllen zu versehen.

28. Vorrichtung nach einem der Ansprüche 20 - 24, wobei die erste Menge und die zweite Menge der Vektoren externe Hüllvektoren umfassen.

29. Vorrichtung nach einem der Ansprüche 20 - 28, die ferner aufweist:
Mittel, um die Verwindung der Hüllen durch eine Technik herabzusetzen, die aus der Gruppe bestehend aus Ösen (Smalleys), Nieten, Waben, Mehrfachdurchlauf und einer beliebigen Kombination davon ausgewählt ist.

30. Vorrichtung nach einem der Ansprüche 20 - 29, die Mittel umfaßt, um die erste Menge von Hüllvektoren so zu definieren, daß sie eine erste und zweite Untermenge von Hüllvektoren umfaßt, wobei die Hüllvektoren der ersten Untermenge nicht benachbarte Hüllvektoren sind, und die Hüllvektoren der zweiten Untermenge zwischen den Hüllvektoren der ersten Untenmenge liegen.

31. Vorrichtung nach einem der Ansprüche 20 - 30, wobei die Hüllvektoren der ersten Menge und die der zweiten Menge senkrecht aufeinander stehen.

32. Vorrichtung nach einem der Ansprüche 19 - 31, wobei das Material eine Flüssigkeit umfaßt.

33. Vorrichtung nach einem der Ansprüche 19 - 32, wobei das Material einen Photopolymer umfaßt.

34. Vorrichtung nach einem der Ansprüche 19 - 31, wobei das Material ein Pulver umfaßt.

35. Vorrichtung nach einem der Ansprüche 19 - 34, wobei die synergistische Stimulierung ein UV-Laserstrahl ist.

36. Vorrichtung nach einem der Ansprüche 20 - 35, wobei der Abstand zwischen aufeinanderfolgenden Hüllvektoren im Bereich zwischen ungefähr 0,025 - 0,1 mm (ungefähr 1 - 4 mils) liegt, für eine maximale Aushärtbreite einer einzelnen Exposition, die ungefähr 0,356 bis 0,381 mm (14 - 15 mils) ist.

## Revendications

**Revendications pour les Etats contractants suivants : DE, FR, GB, NL**

1. Un procédé stéréolithographique pour construire un objet tridimensionnel couche par couche à partir d'un matériau solidifiable par exposition à une stimulation synergique, comprenant les étapes suivantes :
solidification d'une première peau sur au moins une première partie d'une première couche, comprenant plus que les surfaces extérieures de l'objet, par exposition sélective du matériau à une stimulation synergique produisant un premier ensemble de vecteurs de peau parallèles;
solidification d'une seconde peau sur au moins une seconde partie d'une seconde couche ou la première peau de la première couche par exposition sélective du matériau à une stimulation synergique produisant un second ensemble de vecteurs de peau parallèles, où
les vecteurs du premier ensemble ne sont pas parallèles aux vecteurs du second ensemble.

**2.** Le procédé de la revendication 1 comprenant en outre l'étape de :
solidification d'une frontière de la première couche par exposition du matériau en un motif vectoriel qui trace la frontière de la première couche.

**3.** Le procédé des revendications 1 et 2, où la seconde couche est la couche formée de façon immédiatement consécutive après formation de la première couche.

**4.** Le procédé de la revendication 3, où chaque couche est au moins partiellement formée en peau et la direction de formation en peau est inversée entre chaque couche formée de façon immédiatement consécutive.

**5.** Le procédé de l'une des revendications 1 à 4, comprenant en outre l'étape de :
solidification d'une partie d'une couche par exposition sélective du matériau à une stimulation synergique comprenant au moins un premier ensemble de lignes de hachurage.

**6.** Le procédé de l'une des revendications 1 à 5, où les parties à exposer définissent un motif de carrelage.

**7.** Le procédé de l'une des revendications 1 à 5, où l'on forme en peau toutes les couches de l'objet.

**8.** Le procédé de l'une des revendications 1 à 6, où l'on forme en peau plus que les régions tournées vers le bas et tournées vers le haut, mais moins que toutes les parties de toutes les couches.

**9.** Le procédé de l'une des revendications 1 à 5, où le premier ensemble et le second ensemble de vecteurs comprennent des vecteurs de peau externe.

**10.** Le procédé de l'une des revendications 1 à 9, comprenant en outre l'étape d' :
utilisation d'une technique choisie dans le groupe constitué par les *smalleys* [cavités de libération de contraintes], les *rivets* [liaisons ponctuelles], les *webs* [voiles de support], les passes multiples et toute combinaison de ces techniques pour réduire la distorsion des peaux.

**11.** Le procédé de l'une des revendications 1 à 10, où le premier ensemble de vecteurs de peau comprend des premiers et des seconds sous-ensembles de vecteurs de peau, les vecteurs de peau du premier sous-ensemble étant des vecteurs de peau non adjacents et les vecteurs de peau du second sous-ensemble étant intercalés entre les vecteurs de peau du premier sous-ensemble.

**12.** Le procédé de l'une des revendications 1 à 11, où le premier ensemble de vecteurs de peau est perpendiculaire au second ensemble de vecteurs de peau.

**13.** Le procédé de l'une des revendications 1 à 12, où le matériau comprend un liquide.

**14.** Le procédé de l'une des revendications 1 à 13, où le matériau comprend un photopolymère.

**15.** Le procédé de l'une des revendications 1 à 12, où le matériau comprend une poudre.

**16.** Le procédé de l'une des revendications 1 à 15, où la stimulation synergique est un faisceau laser UV.

**17.** Le procédé de l'une des revendications 1 à 16, où l'espacement entre vecteurs de peau consécutifs est compris entre environ 0,025 et environ 0,1 mm (environ 1 à environ 4 *mils*) pour une largeur de durcissement maximale d'une exposition unique d'environ 0,356 à 0,381 mm (14 à 15 *mils*).

**18.** Un dispositif stéréolithographique pour construire un objet tridimensionnel couche par couche à partir d'un matériau semblable à un fluide solidifiable par exposition à une stimulation synergique, comprenant :
des moyens pour solidifier une première peau sur au moins une première partie d'une première couche, comprenant plus que les surfaces extérieures de l'objet, par exposition sélective du matériau à une stimulation synergique produisant un premier ensemble de vecteurs de peau parallèles ;
des moyens pour solidifier une seconde peau sur au moins une seconde partie d'une seconde couche ou la première peau de la première par exposition sélective du matériau à une stimulation synergique produisant un second ensemble de vecteurs de peau parallèles, où
les vecteurs du premier ensemble ne sont pas parallèles aux vecteurs du second ensemble.

**19.** Le dispositif de la revendication 18 comprenant en outre :
des moyens pour solidifier une frontière de la première couche par exposition du matériau en un motif vectoriel qui trace la frontière de la première couche.

**20.** Le dispositif des revendications 18 ou 19, où la seconde couche est la couche formée de façon immédiatement consécutive après formation de la première couche.

**21.** Le dispositif de la revendication 20, où chaque couche est au moins partiellement formée en peau et la direction de formation en peau est inversée entre chaque couche formée de façon immédiatement consécutive.

**22.** Le dispositif de l'une des revendications 18 à 21, comprenant en outre :
des moyens pour solidifier une partie d'une couche par exposition sélective du matériau à une stimulation synergique comprenant au moins un premier ensemble de lignes de hachurage.

**23.** Le dispositif de l'une des revendications 18 à 22, comprenant des moyens pour définir lesdites parties à exposer comme motif de carrelage.

**24.** Le dispositif de l'une des revendications 18 à 22, comprenant des moyens pour former en peau toutes les couches de l'objet.

**25.** Le dispositif de l'une des revendications 18 à 23, comprenant des moyens pour former en peau plus que les régions tournées vers le bas et tournées vers le haut, mais moins que toutes les parties de toutes les couches.

**26.** Le dispositif de l'une des revendications 18 à 22, où le premier ensemble et le second ensemble de vecteurs comprennent des vecteurs de peau externe.

**27.** Le dispositif de l'une des revendications 18 à 26, comprenant en outre :
des moyens pour utiliser une technique choisie dans le groupe constitué par les *smalleys* [cavités de libération de contraintes], les *rivets* [liaisons ponctuelles], les *webs* [voiles de support], les passes multiples et toute combinaison de ces techniques pour réduire la distorsion des peaux.

**28.** Le dispositif de l'une des revendications 18 à 27, comprenant des moyens pour définir le premier ensemble de vecteurs de peau en comprenant des premiers et des seconds sous-ensembles de vecteurs de peau, les vecteurs de peau du premier sous-ensemble étant des vecteurs de peau non adjacents et les vecteurs de peau du second sous-ensemble étant intercalés entre les vecteurs de peau du premier sous-ensemble.

**29.** Le dispositif de l'une des revendications 18 à 28, où le premier ensemble de vecteurs de peau est perpendiculaire au second ensemble de vecteurs de peau.

**30.** Le dispositif de l'une des revendications 18 à 29, où le matériau comprend un liquide.

**31.** Le dispositif de l'une des revendications 18 à 30, où le matériau comprend un photopolymère.

**32.** Le dispositif de l'une des revendications 18 à 29, où le matériau comprend une poudre.

**33.** Le dispositif de l'une des revendications 18 à 32, où la stimulation synergique est un faisceau laser UV.

**34.** Le dispositif de l'une des revendications 18 à 33, où l'espacement entre vecteurs de peau consécutifs est compris entre environ 0,025 et environ 0,1 mm (environ 1 à environ 4 *mils*) pour une largeur de durcissement maximale d'une exposition unique d'environ 0,356 à 0,381 mm (14 à 15 *mils*).

**Revendications pour les Etats contractants suivants : IT, SE, LI, CH, BE, AT, LU, ES, GR, DK**

**1.** Un procédé stéréolithographique pour construire un objet tridimensionnel couche par couche à partir d'un matériau semblable à un fluide solidifiable par exposition à une stimulation synergique, comprenant les étapes suivantes :
solidification d'une première peau sur au moins une première partie d'une première couche, comprenant plus que les surfaces extérieures de l'objet, par exposition sélective du matériau à une stimulation synergique produisant un premier ensemble de lignes de peau parallèles ;
solidification d'une seconde peau sur au moins une seconde partie d'une seconde couche ou la première peau de la première couche par exposition sélective du matériau à une stimulation synergique produisant un second ensemble de lignes de peau parallèles, où
les lignes du premier ensemble ne sont pas parallèles aux lignes du second ensemble.

2. Le procédé de la revendication 1, dans lequel le premier et le second ensemble de lignes de peau sont produits par des données vectorielles.

3. Le procédé de la revendication 2 comprenant en outre l'étape de :
solidification d'une frontière de la première couche par exposition du matériau en un motif vectoriel qui trace la frontière de la première couche.

4. Le procédé de l'une des revendications 1 à 3, où la seconde couche est la couche formée de façon immédiatement consécutive après formation de la première couche.

5. Le procédé de la revendication 4, où chaque couche est au moins partiellement formée en peau et la direction de formation en peau est inversée entre chaque couche formée de façon immédiatement consécutive.

6. Le procédé de l'une des revendications 1 à 5, comprenant en outre l'étape de :
solidification d'une partie d'une couche par exposition sélective du matériau à une stimulation synergique comprenant au moins un premier ensemble de lignes de hachurage.

7. Le procédé de l'une des revendications 1 à 6, où les parties à exposer définissent un motif de carrelage.

8. Le procédé de l'une des revendications 1 à 6, où l'on forme en peau toutes les couches de l'objet.

9. Le procédé de l'une des revendications 1 à 7, où l'on forme en peau plus que les régions tournées vers le bas et tournées vers le haut, mais moins que toutes les parties de toutes les couches.

10. Le procédé de l'une des revendications 2 à 6, où le premier ensemble et le second ensemble de vecteurs comprennent des vecteurs de peau externe.

11. Le procédé de l'une des revendications 2 à 10, comprenant en outre l'étape d' :
utilisation d'une technique choisie dans le groupe constitué par les *smalleys* [cavités de libération de contraintes], les *rivets* [liaisons ponctuelles], les *webs* [voiles de support], les passes multiples et toute combinaison de ces techniques pour réduire la distorsion des peaux.

12. Le procédé de l'une des revendications 2 à 11, où le premier ensemble de vecteurs de peau comprend des premiers et des seconds sous-ensembles de vecteurs de peau, les vecteurs de peau du premier sous-ensemble étant des vecteurs de peau non adjacents et les vecteurs de peau du second sous-ensemble étant intercalés entre les vecteurs de peau du premier sous-ensemble.

13. Le procédé de l'une des revendications 2 à 12, où le premier ensemble de vecteurs de peau est perpendiculaire au second ensemble de vecteurs de peau.

14. Le procédé de l'une des revendications 1 à 13, où le matériau comprend un liquide.

15. Le procédé de l'une des revendications 1 à 14, où le matériau comprend un photopolymère.

16. Le procédé de l'une des revendications 1 à 13, où le matériau comprend une poudre.

17. Le procédé de l'une des revendications 1 à 16, où la stimulation synergique est un faisceau laser UV.

18. Le procédé de l'une des revendications 2 à 17, où l'espacement entre vecteurs de peau consécutifs est compris entre environ 0,025 et environ 0,1 mm (environ 1 à environ 4 *mils*) pour une largeur de durcissement maximale d'une exposition unique d'environ 0,356 à 0,381 mm (14 à 15 *mils*).

19. Un dispositif stéréolithographique pour construire un objet tri-dimensionnel couche par couche à partir d'un matériau semblable à un fluide solidifiable par exposition à une stimulation synergique, comprenant :
des moyens pour solidifier une première peau sur au moins une première partie d'une première couche, comprenant plus que les surfaces extérieures de l'objet, par exposition sélective du matériau à une stimulation synergique produisant un premier ensemble de lignes de peau parallèles ;
des moyens pour solidifier une seconde peau sur au moins une seconde partie d'une seconde couche ou la partie ne formant pas frontière de la première couche par exposition sélective du matériau à une stimulation synergique produisant un second ensemble de lignes de peau parallèles, où
les lignes du premier ensemble ne sont pas parallèles aux lignes du second ensemble.

20. Le procédé de la revendication 19, dans lequel les moyens pour solidifier comprennent des moyens pour produire les lignes de peau des premier et second ensembles par des données vectorielles.

21. Le dispositif de l'une des revendication 19 ou 20, comprenant en outre :
des moyens pour solidifier une frontière de la première couche par exposition du matériau en un motif vectoriel qui trace la frontière de la première couche.

22. Le dispositif de l'une des revendications 19 à 21, où la seconde couche est la couche formée de façon immédiatement consécutive après formation de la première couche.

23. Le dispositif de la revendication 22, où chaque couche est au moins partiellement formée en peau et la direction de formation en peau est inversée entre chaque couche formée de façon immédiatement consécutive.

24. Le dispositif de l'une des revendications 19 à 23, comprenant en outre :
des moyens pour solidifier une partie d'une couche par exposition sélective du matériau à une stimulation synergique comprenant au moins un premier ensemble de lignes de hachurage.

25. Le dispositif de l'une des revendications 19 à 24, comprenant des moyens pour définir lesdites parties à exposer comme motif de carrelage.

26. Le dispositif de l'une des revendications 19 à 24, comprenant des moyens pour former en peau toutes les couches de l'objet.

27. Le dispositif de l'une des revendications 19 à 25, comprenant des moyens pour former en peau plus que les régions tournées vers le bas et tournées vers le haut, mais moins que toutes les parties de toutes les couches.

28. Le dispositif de l'une des revendications 20 à 24, prises en dépendance de la revendication 20, où le premier ensemble et le second ensemble de vecteurs comprennent des vecteurs de peau externe.

29. Le dispositif de l'une des revendications 20 à 28, comprenant en outre :
des moyens pour utiliser une technique choisie dans le groupe constitué par les *smalleys* [cavités de libération de contraintes], les *rivets* [liaisons ponctuelles], les *webs* [voiles de support], les passes multiples et toute combinaison de ces techniques pour réduire la distorsion des peaux.

30. Le dispositif de l'une des revendications 20 à 29, prises en dépendance de la revendication 20, comprenant des moyens pour définir le premier ensemble de vecteurs de peau en comprenant des premiers et des seconds sous-ensembles de vecteurs de peau, les vecteurs de peau du premier sous-ensemble étant des vecteurs de peau non adjacents et les vecteurs de peau du second sous-ensemble étant intercalés entre les vecteurs de peau du premier sous-ensemble.

31. Le dispositif de l'une des revendications 20 à 30, prises en dépendance de la revendication 20, où le premier ensemble de vecteurs de peau est perpendiculaire au second ensemble de vecteurs de peau.

32. Le dispositif de l'une des revendications 19 à 31, où le matériau comprend un liquide.

33. Le dispositif de l'une des revendications 19 à 32, où le matériau comprend un photopolymère.

34. Le dispositif de l'une des revendications 19 à 31, où le matériau comprend une poudre.

35. Le dispositif de l'une des revendications 19 à 34, où la stimulation synergique est un faisceau laser UV.

**36.** Le dispositif de l'une des revendications 20 à 35, prises en dépendance de la revendication 20, où l'espacement entre vecteurs de peau consécutifs est compris entre environ 0,025 et environ 0,1 mm (environ 1 à environ 4 *mils*) pour une largeur de durcissement maximale d'une exposition unique d'environ 0,356 à 0,381 mm (14 à 15 *mils*).

Fig. 1a.

Fig. 1b.

Fig. 1c.

Fig. 1d.

Fig. 2a.

Fig. 2b.

Fig. 2c.

Fig. 2d.

42

Fig. 3a.

Fig. 3b.

Fig. 3c.

Fig. 3d.

Fig. 3e.

*Fig. 4a*

*Fig. 4b*

*Fig. 4c.*

*Fig. 4d*

*Fig. 5a*

*Fig. 5b*

UP

DOWN

PART 5

*FIG. 6a.*

PART 6

*FIG. 6b.*

PART 7

*FIG. 6c.*

PART 8

*FIG. 6d.*

*Fig. 1a.*

*Fig. 1b.*

*Fig. 1c.*

Fig. 8a.

Fig. 8b.

LAYER THICKNESS

Fig. 8c.

Fig. 8d.

LAYER THICKNESS

Fig. 8e.

Fig. 8f.

LAYER THICKNESS

FIG. 8g

FIG. 8h

FIG. 8i

302    304    306    308    310    312

BOUNDARY

CROSS
HATCH

FIG. 9a.

320

FIG. 9b.

*FiG. 10a.*

*FiG. 11.*

*FiG. 10b.*

*FiG. 12.*

*FiG. 10c.*

Fig. 13

INDICATES SOLID REGIONS ⊡

Fig. 14a.

Fig. 14b.

CROSS SECTION #

☐ DOWN FACING SKINNED REGIONS

☐ UP FACING SKINNED REGIONS

☒ REGIONS SKINNED ACCORDING TO THIS EMBODIMENT

FIG. 15a.

FIG. 15b.

FIG. 15c.

POST CURE RADIATION

POST CURE RADIATION

_FIG. 16a._

_FIG. 16b._

_FIG. 16b'._

HEXAGONAL TILE

GROUT LINES

PARTIAL TILE
RESULTING FROM
A FIXED TILE
PLACEMENT GRID
MEETING A
BOUNDARY

NO EASY BENDING AXIS

PORTION OF A CROSS-SECTIONAL
LAYER FORMED USING HEXAGONAL
TILES

Fig. 11 a.

TRIANGULAR TILE

GROUT LINES

NO EASY BENDING AXIS

PORTION OF A CROSS-SECTIONAL
LAYER FORMED USING ARBIT-
RARILY ORIENTED AND SIZED
TRIANGULAR TILES.

Fig. 11 b.

TRIANGULAR TILE

GROUT LINE

EASY BENDING AXIS (ONLY ONE)

PORTION OF A CROSS-SECTIONAL LAYER
FORMED USING HIGH ORDER TRIANGLES.

Fig. 11 c.

SQUARE TILE

GROUT LINE

EASY BENDING AXIS (ONLY ONE)

PORTION OF A CROSS SECTIONAL LAYER FORMED USING A STAGGERED (XY) ARRAY OF SQUARE TILES.

FIG. 11d

EASY BENDING AXIS (#2)

SQUARE TILE

GROUT LINE

EASY BENDING AXIS (#1)

PORTION OF A CROSS-SECTIONAL LAYER FORMED USING A REGULAR ARRAY OF SQUARE TILES.

FIG. 11e

EASY BENDING AXIS (#2)

TRIANGULER TILE

GROUT LINE

EASY BENDING AXIS (#1)

PORTION OF A CROSS-SECTIONAL LAYER FORMED USING A REGULAR ARRAY OF OPPOSITELY PAIRED TRIANGLES.

Fig. 11 f

EASY BENDING AXIS (#2)

TRIANGULAR TILE
GROUT LINE

EASY BENDING AXIS (#3)

EASY BENDING AXIS (#1)

PORTION OF A CROSS-SECTIONAL LAYER FORMED USING TRIANGLES FITTED IN A SQUARE REGULAR ARRAY.

Fig. 11 g